(19) Europäisches Patentamt

European Patent Office

Office européen des brevets

(11) **EP 1 457 823 A2**

(12) **EUROPEAN PATENT APPLICATION**

(43) Date of publication:
**15.09.2004 Bulletin 2004/38**

(51) Int Cl.⁷: **G03F 7/09**

(21) Application number: **04005821.6**

(22) Date of filing: **11.03.2004**

(84) Designated Contracting States:
**AT BE BG CH CY CZ DE DK EE ES FI FR GB GR
HU IE IT LI LU MC NL PL PT RO SE SI SK TR**
Designated Extension States:
**AL LT LV MK**

(30) Priority: **12.03.2003 US 454073 P**

(71) Applicant: **E.I. DU PONT DE NEMOURS AND
COMPANY**
**Wilmington, Delaware 19898 (US)**

(72) Inventors:
• **Rudolph, Michael Lee**
**Newark Delaware 19711 (US)**

• **Blackman, Gregory Scott**
**Media Pennsylvania 19063 (US)**
• **Bode, Udo Dietrich**
**63303 Dreieich (DE)**
• **Lungu, Violeta**
**Old Bridge New Jersey 08857 (US)**
• **Shock, John R.**
**Princeton New Jersey 08550 (US)**

(74) Representative: **Thomson, James B.**
**Frank B. Dehn & Co.**
**179 Queen Victoria Street**
**London EC4V 4EL (GB)**

(54) **Photosensitive element for use as flexographic printing plate**

(57)     A photosensitive element for use as a flexographic printing plate comprises a support, an elastomeric photopolymerizable layer having a surface opposite the support that defines a plane, and a matted layer disposed above the surface of the photopolymerizable layer comprising a polymeric binder and at least one matting agent which is capable of forming depressions from the plane into the photopolymerizable layer. Also described is a process for preparing such a photosensitive element and a process for preparing a flexographic printing plate from the photosensitive element.

**FIG. 6**

**Description**

FIELD OF THE INVENTION

This invention pertains to a photosensitive element for use as a flexographic printing plate. Furthermore, the invention pertains to a process for preparing the photosensitive element, a process for preparing a flexographic printing plate from the photosensitive element, and the flexographic printing plate made by that process.

BACKGROUND OF THE INVENTION

Flexographic printing plates are well known for use in relief printing on a variety of substrates such as paper, corrugated board, films, foils and laminates. Flexographic printing plates can be prepared from photosensitive elements comprising a photopolymerizable layer containing an elastomeric binder, a monomer, and a photoinitiator, interposed between a support and a cover sheet or multilayer cover element. A preferred process of making such photosensitive elements is described in US 4,460,675 where a previously extruded photopolymerizable composition is fed into the nip of a calender and is calendered between a support and a multilayer cover element to form a photopolymerizable layer. Upon imagewise exposure of the photosensitive element with actinic radiation through a photomask, the exposed areas of the photopolymerizable layer are insolubilized. Treatment with a suitable solvent removes the unexposed areas of the photopolymerizable layer leaving a printing relief which can be used for flexographic printing. Such materials are described in US 4,323,637; US 4,427,759; and US 4,894,315.

A common technique for bringing a photosensitive element and a photomask into close contact with one another is to juxtapose the elements and draw a vacuum from between them usually by use of a vacuum frame. When smooth-surfaced elements are brought into such vacuum contact, however, the time required to evacuate air from between the elements and obtain a substantially uniform and complete contact between them becomes exceedingly high. Moreover, even after long periods of time, uniform and complete contact might not be achieved and the photomask may stick so strongly to the photosensitive element that it is damaged when stripped off.

Sometimes, at least one of the photosensitive element or the photomask has a rough outermost layer to avoid these disadvantages. Use of photomasks having rough surfaces are disclosed in US 4,997,735 and US 5,124,227. It is also known to use photosensitive elements with rough outermost layers in combination with photomasks having a smooth surface. Several methods are known to provide such rough layers. Cover sheets having a rough layer are stripped off from the photosensitive element, before or after contacting the photomask with the photosensitive element thereby transferring their roughness to the surface of the photosensitive element. Such processes are described in US 5,294,474; US 4,994,344; US 4,957,845; US 4,567,128; US 4,559,292; US 3,891,443; EP-A 0 549 946; DE-C 26 31 837. Furthermore, it is known to incorporate a small amount of particles into the photosensitive layer itself as disclosed by US 4,599,299; US 4,560,636; US 4,298,678; US 3,891,443; EP-A 0 549 946; EP-A 0 260 943. Such particles can also be incorporated into a temporary protective layer, the so called "release layer", which is a flexible and transparent polymeric film on top of the photosensitive layer and which is removed during development of the imagewise exposed photosensitive elements, as disclosed by US 6,040,116; US 5,593,811; US 5,254,437; US 4,238,560; US 4,072,527; EP-A 0 617 331; DE-A 41 17 127; DE-A 25 12 043; DE-C 21 27 767. It is also known that in addition to the better vacuum contact, a rough outermost layer can also improve the print quality of the final printing plate. However, it is believed that such elements do not provide the printing surface with the properties necessary to improve the print quality to a significant degree as determined by multiple printing characterizations such as ink transfer, dot gain, and reproduction of fine text.

But incorporation of particles into photosensitive layers or release layers may lead to difficulties during development of the imagewise exposed photosensitive elements, for example, sludge deposits in the development processor. Therefore, special materials and processes are used, such as, special polymeric particles having the same composition as the photosensitive layer, and incorporating particles by special process steps, such as spray coating or embossing the surface of the photosensitive element after it has been produced. These techniques are disclosed in US 5,795,647; US 5,576,137; US 5,028,512; US 4,842,982; US 4,557,994; US 4,288,526; EP-A 1 014 194; EP-A 0 649 063; EP-A 0617 331; EP-A 0152 653; DE-C 30 09 928. But these techniques are elaborate because they are restricted to special materials and always require additional process steps. In particular, altering the printing surface of the plate by embossing techniques do not provide the desired topography of the printing surface since by embossing both depressions into and protrusions above the nominal surface of the photopolymerizable layer are created. (The protrusions essentially are only a mass of the photopolymerizable material.) Hereto, it is believed that such elements do not provide the printing surface with the properties necessary to improve the print quality to a significant degree as determined by multiple printing characterizations, such as ink transfer, dot gain, and reproduction of fine text.

Therefore, it is an object of the present invention to provide photosensitive elements for preparing flexographic printing plates which show significant improvements in printing quality as measured by several printing characterizations. It is a further object of the present invention to provide photosensitive elements for preparing flexographic printing plates that provide the printing surface of the plate with a surface topography that is different from those of the prior art.

## SUMMARY OF THE INVENTION

These objectives are solved by a photosensitive element for use as a flexographic printing plate comprising (a) a support, (b) at least one elastomeric photopolymerizable layer on the support containing at least one elastomeric binder, at least one ethylenically unsaturated compound photopolymerizable by actinic radiation, and at least one photoinitiator or photoinitiator system, the elastomeric photopolymerizable layer having a surface opposite the support that defines a plane; and (c) a matted layer disposed above the surface of the photopolymerizable layer comprising a polymeric binder and at least one matting agent. The at least one matting agent is capable of forming depressions from the plane into the photopolymerizable layer, and selected from the group consisting of

i) matting agents having a pore volume of $\geq$ 0.9 ml/g;
ii) matting agents having a BET surface of $\geq$ 150 $m^2$/g;
iii) matting agents having an oil number of $\geq$ 150g/100g;
iv) matting agents having at least one crosslinkable group; and
v) combinations thereof.

In accordance with the invention there is also provided a process for preparing the photosensitive element and a process for preparing a flexographic printing plate from the photosensitive element.

## BRIEF DESCRIPTION OF THE DRAWINGS

The invention can be more fully understood from the following detailed description thereof in connection with the accompanying drawing described as follows:

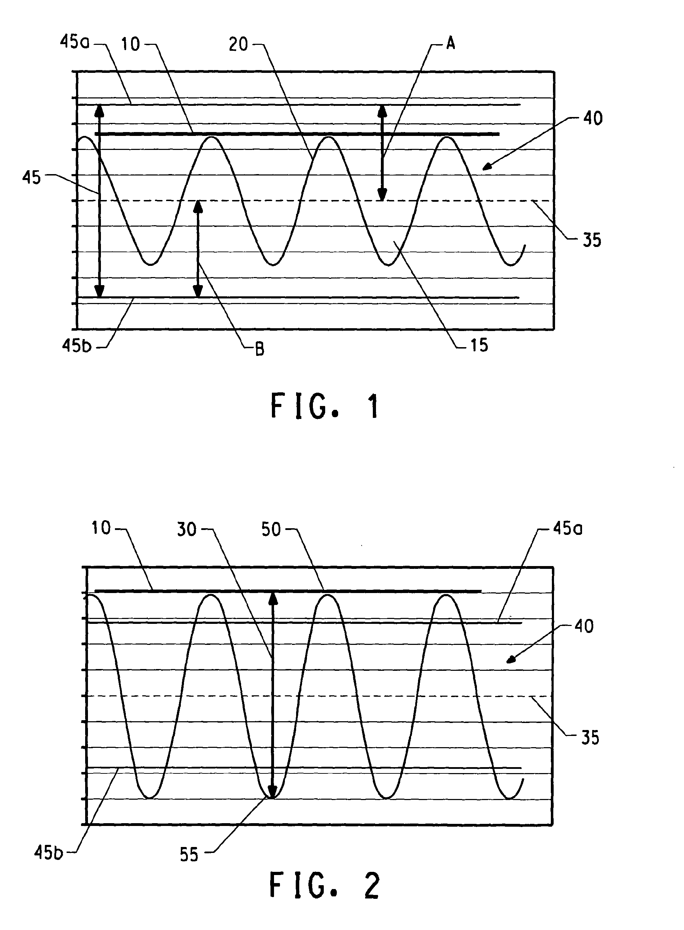

FIGURE 1 is a schematic representation of a cross-sectional view of a topography of a surface of a photopolymerizable layer representing depressions at or below a plane at the surface of the photopolymerizable layer, and showing various properties that the depressions can be characterized by, including data set of surface pixels (in two dimensions), a mean surface height, a reference band width, upper and lower reference bands, surface depression, and surface protrusion.

FIGURE 2 is a schematic representation of a cross-sectional view of a topography of a surface of a photopolymerizable layer similar to FIGURE 1 representing depressions at or below a plane at the surface of the photopolymerizable layer, and showing various additional properties that the depressions can be characterized by including a depression depth, a surface peak, and a surface pit.

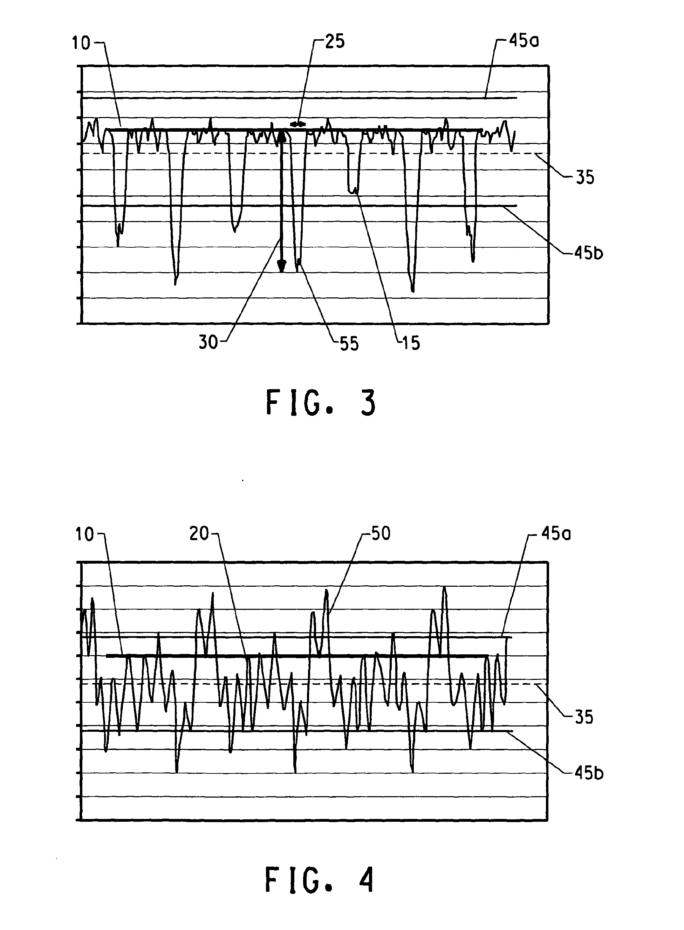

FIGURE 3 is a schematic representation of a cross-sectional view of a topography of a surface of a photopolymerizable layer which represents various depressions which can occur at or below a plane at the surface of the photopolymerizable layer, and showing various properties including depression opening size, depression depth, surface depression, and the surface pit.

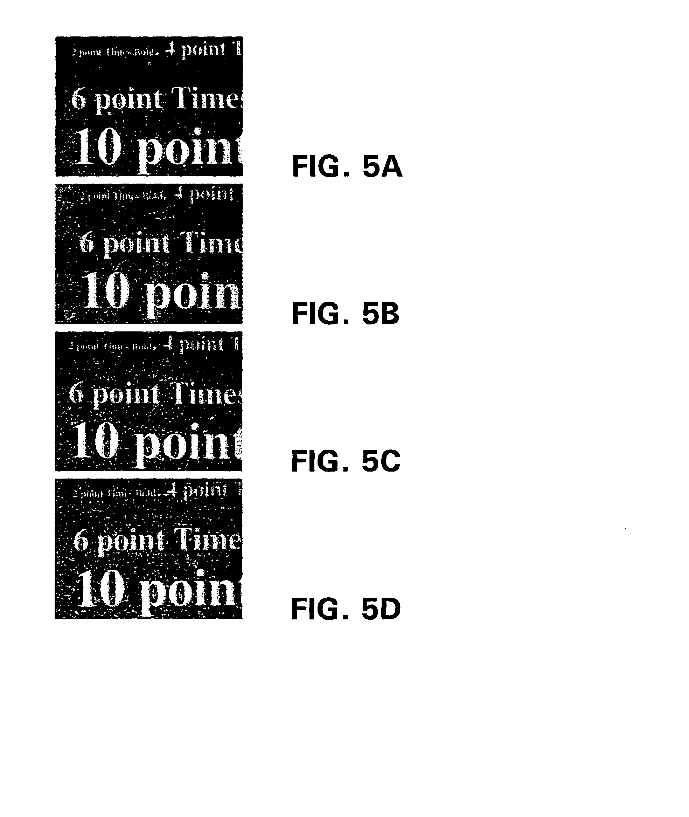

FIGURE 4 is a schematic representation of another cross-sectional view of a topography of a surface of a photopolymerizable layer which represents various depressions which can occur at or below a plane at the surface of the photopolymerizable layer, and showing various properties including a surface protrusion and the surface peak.

FIGURES 5a, 5b, 5c, and 5d are a series of images printed by various plates tested in Example 1 and discussed in Example 3. Figure 5a was a printed image provided by the plate of Example 1A. Figure 5b was a printed image provided by the plate of Comparative Example 1 G. Figure 5c was a printed image provided by the plate of Comparative Example.1 F. Figure 5d was a printed image provided by the plate of Comparative Example 1 C.

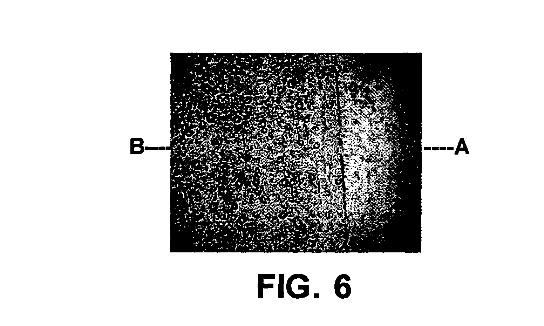

FIGURE 6 is a micrograph showing a side-by-side comparison of a surface of a photopolymerizable layer in which side B was given an exposure to retain the surface topography of depressions below a plane at the surface of the photopolymerizable layer, and side A was not exposed and does not retain the surface topography.

## DETAILED DESCRIPTION OF THE PREFERRED EMBODIMENT(S)

The present invention provides for a flexographic printing plate prepared from a photosensitive element having a matted layer on a photopolymerizable layer which provides a unique surface topography to the photopolymerizable layer. The present invention also provides for a flexographic printing plate prepared from the photosensitive element having significantly improved printing performance as shown in ink transfer and several printing attributes than flexographic printing plates of the prior art. Further, the flexographic printing plate made from the photosensitive element has enhanced print life. The present invention can be integrated in usual production processes with no additional, special production steps being necessary. It can be adopted for all sorts of flexographic printing plates and various types of flexographic composition.

An advantage of the present photosensitive element is that during printing the flexographic printing plate made from this photosensitive element picks up less deposits of paper fibers and dried ink which would fill in reverses areas of the plate. Therefore, high printing quality can be maintained much longer than with former flexographic printing plates and the time between plate cleanings during the printing press run can be extended, resulting in higher productivity.

A main advantage of the present invention is that the flexographic printing plate made from the photosensitive element has a unique surface topography characterized by depressions in the photopolymerizable layer that provides significantly improved printing quality. The improvement in printing quality is observed for several printing characterizations or attributes including, uniformity of ink transfer during the printing process, dot gain, and reproduction of fine text. An improvement in the uniformity of ink transfer is determined by an increase in the amount of ink transferred from the plate to the substrate and/or an increase in the uniformity of laydown of the ink on the substrate, as determined by density in the areas of solid ink coverage. When a printed dot is larger than the corresponding dot on the plate, the growth of the printed dot is referred to as dot gain. It is desirable to minimize dot gain, since lower dot gain provides for improved tone reproduction in a printed image. And an improvement in the reproduction of quality of fine text is observed for both positive text and negative text.

Matted layer

The matted layer of the photosensitive element comprises a polymeric binder and at least one matting agent which is capable of forming depressions from a plane into the photopolymerizable layer. The at least one matting agent when disposed above the photopolymerizable layer is capable of forming depressions into a surface of the photopolymerizable layer opposite the support. After the matted layer is brought into contact with the photopolymerizable layer, the matting agent creates the depressions into the photopolymerizable layer during exposure to actinic radiation and treatment.

The matting agent is selected from the group consisting of i) matting agents having a pore volume of $\geq 0.9$ ml/g, ii) matting agents having a BET surface of $\geq 150$ $m^2$/g, iii) matting agents having an oil number of $\geq 150$ g/100 g, iv) matting agents having at least one crosslinkable group; and v) combinations thereof.

The pore volume of the matting agent under i) is determined by titration with water. The test sample is activated by heating for 2 hours at 200 °C. 10-40 g of the test sample are weighed into a screw top jar. Sufficient water is added from a burette to fill about 80 % of the expected pore volume. The jar is then vigorously shaken to distribute the water evenly throughout the sample. The sample is cooled to room temperature under cold water and further small additions of water are made until a saturated gel has formed, which adheres to the base of the jar when inverted. At this point the water has filled all of the pores and begins to cover the external surface of the sample. After each addition the jar is shaken vigorously. The pore volume is calculated by: pore volume (ml/g) = quantity of water added (ml)/ weight of sample (g). Preferably, a matting agent with a pore volume of 1.0-2.5 ml/g is used. Especially matting agents with a pore volume of 1.5-2.5 ml/g are suitable.

BET surface means the specific surface determined according to the method of Brunauer, Emmett, and Teller (see also DIN 66131). By this method, the volume of nitrogen gas is measured, which is adsorbed on the surface of the adsorbing material at -196 °C dependent upon the applied pressure. This method is well known to those skilled in the art. Preferably, a matting agent with a BET surface of $\geq 200$ $m^2$/g is used. Especially matting agents with a BET surface of $\geq 280$ $m^2$/g are suitable.

The oil number is measured according to DIN ISO 787-5 (ASTM D 281). The oil number represents the amount of oil in grams necessary to process 100 g of a pigment (here the matting agent) to form an adhering cementlike mass. Preferably, a matting agent with an oil number of $\geq 200$ g/100 g is used. Especially matting agents with an oil number of $\geq 250$ g/100 g are suitable.

The term "crosslinkable group" for matting agents having at least one crosslinkable group of iv) is intended to encompass photopolymerizable and photocrosslinkable groups as well as such groups which are thermally crosslinkable. Preferred crosslinkable groups are ethylenically unsaturated groups, such as, e.g., vinyl groups, acryloyl groups or methacryloyl groups, and epoxy groups. Especially preferred are ethylenically unsaturated groups. Matting agents comprising such crosslinkable groups are prepared by conventional surface modification of silicic acids or silica matting agents with silanes comprising the crosslinkable group and an alkoxy group or halogen atom. Such surface modifications are described in DE-A 33 25 064 and DE-B 23 04 602.

Preferably, the matting agent has a mean particle size of $\geq 3$ µm. The mean particle size is the particle size determined according to ASTM-D 4438-85 (Coulter Counter method). Especially suitable are matting agents having a mean particle size of 3-15 µm. Preferably, $\geq 60$ % by weight of the total particles of the matting agent are between 3

to 15 μm; especially preferred are ≥ 80 % by weight. The matting agent may include ≤ 20 % by weight of particles with a particle size of ≥ 15 μm. Furthermore, the matting agent may comprise ≥ 10 %, preferably 10-20 %, by weight of particles with a particle size of ≤ 3 μm, preferably ≤ 2 μm.

It is advantageous to use a matting agent having a combination of the particle characteristics described for i), ii), iii), and/or iv). A matting agent having a mean particle size of ≥ 3 μm, a pore volume of ≥ 0.9 ml/g, and an oil number of ≥ 150 g/100 g is suitable, and further including a BET surface of ≥150 $m^2$/g is particularly suitable. Most suitable are those matting agents having a mean particle size of ≥ 3 μm, a pore volume of 1.0-2.5 ml/g, an oil number of ≥ 200 g/100 g, and a BET surface of ≥ 200 $m^2$/g.

Preferably, the matting agent has a refractive index similar to that of the other components of the photosensitive element.

The matting agent may be any inorganic or organic matting agent having one or more of the above described properties. Preferably, the matting agent is selected from the group consisting of silicas, silicic acids, silicates, like clays, kaolinites, zeolithes, then aluminas and/or aluminates, and mixtures thereof. Polymer beads may also be suitable as the matting agent.

It is also possible to use a matting agent that is filled and/or loaded with at least one ethylenically unsaturated compound photopolymerizable by actinic radiation. Suitable monomers are those which are used in the photopolymerizable layer and which are disclosed below. Preferably, polar monomers with good adsorption to the surface of the matting particles, especially such with low viscosity and high diffusion capability in the photopolymerizable layer, can be used, for example, hexamethylene glycol diacrylate and/or hexamethylene glycol dimethacrylate. By the use of matting agents filled and/or loaded with monomers it is possible to reduce the aging time of the photosensitive elements after their production which is necessary to equilibrate the photopolymerizable layer to achieve suitable sensitometric characteristics and to equilibrate the photopolymerizable layer and the matted layer for purpose of monomer migration from the photopolymerizable layer into the matted layer, especially into the pores and/or onto the surface of the matting agent. Another possibility to reduce the aging time is to apply heat to the photosensitive element instead of aging at ambient temperature.

Preferably, the matting agent is present in an amount of ≥ 10% by weight of the matted layer, preferably ≥ 15% by weight, and most preferably 15 to 30% by weight. The matting agent may be used in an amount up to 60% by weight of the matted layer.

The matted layer and the photopolymerized printing plate each have surface roughness. Surface roughness, as described herein, is measured with a Hommeltester by profile measurement. The surface roughness Rz according to DIN 4762 of the matted layer alone, i.e., before association with the photopolymerizable layer, is preferably ≥ 3 μm, especially ≥ 5 μm. The surface roughness Rz of the photosensitive element after removal of a cover sheet is preferably ≥ 2 μm, especially ≥ 2.5 μm. The roughness Rz of the printing surface of the flexographic printing plate after treating, and optionally after-treatment, is preferably ≥ 2.5 μm, especially ≥ 3 μm. The printing surface is the raised area/s of the relief which carry ink.

Surface roughness of the exposed and treated flexographic printing plate may also be measured by analysis of data obtained through optical interferometry specifically applying surface roughness measurements Ra and Rq as defined by ISO 4287 or DIN 4762. The surface roughness of the photosensitive element, defined by the property Ra as defined by these methods, after treatment is preferably ≥ 0.75 micron especially ≥ 1.0 micron and the surface roughness of the photosensitive element, defined by the property Rq as defined by these methods, after treatment is preferably ≥ 1.0 micron, especially ≥ 1.5 micron.

Although there are a plurality of methods to describe the roughness of a surface, the most common measurements are generated by a profilometer. The profilometer typically provides a two dimensional representation of the surface expressed as a profile height(y) as a function of scan direction (x). From this information one or more of a number of surface profile parameters can be calculated. Specific parameters, such as Ra, Rq, and Rz(DIN), are often used as descriptors in the patent literature as previously referenced and are calculations based on an analysis of the surface profile. Ra represents the average deviation of the surface profile from the surface profile mean. Rq is a statistical analysis which represents the average of the square of the deviations of the profile from the mean line (i.e., the standard deviation of the profile deviations). Rz(DIN) breaks a profile scan into five equal lengths, determines the maximum peak to valley distance within each of the five subsets of the scan length and averages the five maximum peak to valley excursions of the profile. However, for some surfaces a two-dimensional analysis such as that provided by a profilometer is not sufficient to characterize the true nature of the surface.

As such it is desirable to characterize the surface topography of the printing surface of the printing element by three dimensional surface structure metrics, such as, for example, number of surface depressions, depression area coverage expressed as a percent, and average depression size as will be described.

In addition to the matting agent, the matted layer comprises a polymeric binder. Suitable polymers are soluble or strippable or removable during treating of the photosensitive element. Such are, for example, polyamides such as nylon and nylon copolymers, polyvinyl alcohols, polyurethanes, urethane copolymers such as urethane-acrylic copolymer, polyvinyl pyrrolidones, polyethylene oxides of Mw $\geq$ 100,000, copolymers of ethylene and vinyl acetate, polyacrylates, polyesters, cellulose esters, cellulose ethers, and polyolefins. It is especially preferred to use polyamides. Usually, the polymeric binder is present in an amount of $\leq$ 85 % by weight of the matted layer. Preferably, the matted layer comprises 40-90 % by weight of the polymeric binder.

Optionally, the matted layer may comprise colorants, e.g., dyes and/or pigments as well as photochromic additives, i.e., for identification or for better contrast between imaged and non-imaged areas of the photosensitive elements directly after imagewise exposure or after imagewise exposure and development. These colorants must not interfere with the imagewise exposure of the photopolymerizable layer. Suitable colorants are, e.g., soluble acridine dyes, anthraquinone dyes, phenazine dyes, and phenoxazine dyes, such as, for example, methylene violet (C.I. Basic Violet 5), methylene blue B (C.I. 52015), Solvent Black 3 (C.I.26150), Rhodamin 3 GO (C.I. Basic Red 4), Solvent Blue 11 (C.I. 61525), Victoria Pure Blue BO (C.I. Basic Blue 7 or C.I. 42595), anthraquinone Blue 2 GA (C.I. Acid Blue 58), Safranin T (C.I. 50240), etc. Usually, the colorant is present in an amount of 0.0001-2 % by weight of the matted layer. Preferably, the matted layer comprises 0.001-1 % by weight of the colorant.

The matted layer may optionally form an integrated masking layer for the photosensitive element. As such, the matted layer becomes an infrared (IR) sensitive layer, which means that the matted layer can be imaged with an infrared laser radiation. Therefore, the matted layer can contain material having high infrared absorption in the wavelength range between 750 and 20,000 nm, such as, for example, polysubstituted phthalocyanine compounds, cyanine dyes, merocyanine dyes, etc., inorganic pigments, such as, for example, carbon black, graphite, chromium dioxide, etc., or metals, such as aluminum, copper, etc. The quantity of infrared absorbing material is usually 0.1-40 % by weight, relative to the total weight of the layer. Furthermore, the matted layer in this embodiment is opaque to ultraviolet or visible light, that is, has an optical density $\geq$ 2.5. To achieve this optical density, the matted layer contains a material that prevents the transmission of actinic radiation. This actinic radiation blocking material can be the same or different than the infrared absorbing material, and can be for example, dyes or pigments, and in particular the aforesaid inorganic pigments. The quantity of the radiation blocking material is usually 1-70 % by weight relative to the total weight of the layer. When the matted layer is infrared sensitive, a polymeric binder may be present. The polymeric binder can be the same as those described above for the matted layer alone, or the binder can be one that is suitable for use in an infrared-sensitive layer. Examples of binders suitable for use in the matted-infrared sensitive layer include, but is not limited to, nitrocellulose, homopolymers or copolymers of acrylates, methacrylates and styrenes, polyamides, polyurethanes, polyvinyl alcohols, etc. All these compounds are described in detail, for example in WO 94/03838 and WO 94/3839 which disclose IR-sensitive layers as integrated photomasks for flexographic printing plates.

Other auxiliary agents, such as plasticizers, coating aids, viscosity modifying agents, wetting agents, waxes, surfactants, dispersing agents, etc. can be included in the matted layer. Preferably, waxes with a softening temperature $\geq$ 70 °C, especially polyethylene waxes having a softening temperature $\geq$ 90 °C, can be used. Generally the auxiliary agents can be present in the matted layer up to about 2% by weight of the matte composition.

Conventional methods like slot coating, roll coating, gravure coating, or spray coating are used to prepare the matted layer from a solution or dispersion of the components in suitable solvents. The matted layer is applied on the cover sheet, and subsequently dried. The thickness of the matted layer is usually 0.02-40 $\mu$m, preferably 0.05-20 $\mu$m, especially 0.5-10 $\mu$m with a usual dry coating weight of 0.01-10 $g/m^2$, preferably 0.1-5 $g/m^2$. The dry coating weight of the matting agent usually is 0.001-5 $g/m^2$, preferably 0.01-2 $g/m^2$.

Photopolymerizable layer

The photopolymerizable layer of the photosensitive element for use as flexographic printing plate consist of known photopolymerizable materials. As used herein, the term "photopolymerizable" is intended to encompass systems which are photopolymerizable, photocrosslinkable, or both. All photopolymerizable materials of the state of the art can be used. Especially preferred are the materials disclosed in US 4,323,637; US 4,427,759; and US 4,894,315. They usually comprise at least one elastomeric binder, at least one photopolymerizable, ethylenically unsaturated monomer, and at least one photoinitiator or photoinitiator system, wherein the photoinitiator is sensitive to actinic radiation, which usually includes ultraviolet radiation and/or visible radiation.

Examples of elastomeric binders are polyalkadienes, alkadiene/acrylonitrile copolymers; ethylene/propylene/alkadiene copolymers; ethylene/(meth)acrylic acid((meth)acrylate copolymers; and thermoplastic, elastomeric block copolymers of styrene, butadiene, and/or isoprene. Linear and radial thermoplastic, elastomeric block copolymers of styrene and butadiene and/or isoprene are preferred. Preferably, the binder is present in an amount of $\geq$ 65 % by weight of the photopolymerizable material.

Monomers that can be used in the photopolymerizable layer are well known in the art and include ethylenically unsaturated, copolymerizable, organic compounds, such as, for example, acrylates and methacrylates of monovalent or polyvalent alcohols; (meth)acrylamides; vinyl ethers and vinyl esters; etc., in particular acrylic and/or methacrylic of butanediol, hexanediol, diethylene glykol, trimethylol propane, pentaerythritol, etc.; and mixtures of such compounds.

Preferably, the monomer is present in an amount of ≥ 5 % by weight of the photopolymerizable material.

Suitable photoinitiators are individual photoinitiators or photoinitiator systems, such as, for example, benzoin derivatives, benzil acetals, diary(phosphine oxides, etc., also mixed with triphenyl phosphine, tertiary amines, etc. Preferably, the photoinitiator is present in an amount of 0.001-10.0 % by weight of the photopolymerizable material.

A second photoinitiator sensitive to radiation between 200 to 300 nm, preferably 245 to 265 nm, may optionally be present in the photopolymerizable composition. Typically after treating, a plate can be finished with radiation between 220 to 300 nm to detackify the relief surfaces. The second photoinitiator decreases the finishing exposure time necessary to detackify the plate. The presence of the second photoinitiator may also aid in retaining the surface topography, i.e., depressions into the plane of the photopolymerizable layer, for plates that are main exposed in the presence of atmospheric oxygen. In one embodiment, photosensitive elements that have an integrated photomask are given a pre-exposure to radiation between 200 to 300 nm to harden or cure the surface of the photopolymerizable layer to the extent that the depressions from the plane of the photopolymerizable layer are set in place before the element undergoes the treating step. Benzophenones and mixtures of benzophenones are examples of compounds suitable for use as the second photoinitiator. The second photoinitiator can be present in amounts from 0.001 % to 10.0% based on the weight of the photopolymerizable composition. In addition to the main components described in the foregoing, the photopolymerizable compositions may comprise conventional additives like, for example, UV absorbers, thermal stabilizers, plasticizers, colorants, antioxidants, fillers, etc.

The thickness of the photopolymerizable layer can vary over a wide range depending upon the type of flexographic printing plate desired. For so called "thin plates" the photopolymerizable layer can be from about 0.05-0.17 cm in thickness. Thicker plates will have a photopolymerizable layer up to 0.25-0.64 cm in thickness or greater.

The elastomeric photopolymerizable layer resides on or above a support and has a surface opposite the support that defines a plane 10. The plane 10 at the surface of the photopolymerizable layer is determined by the surface of the photopolymerizable layer at the desired, i.e., original, thickness with no alterations to the surface of the photopolymerizable layer. The plane 10 at the surface of the photopolymerizable layer is determined prior to contact of the matted layer to the photopolymerizable layer, that is, the surface of the photopolymerizable layer is smooth or substantially smooth. After the photopolymerizable layer has been polymerized by exposure and the relief formed by treatment, the surface opposite the support ultimately is the printing surface of the printing element. The printing surface is the raised area/s of the relief which carry ink. The surface of the photopolymerizable layer contains a multiplicity of depressions 15, which may also be called voids, pores, pits, or cavities, into the layer such that the printing surface of the printing element is dominated by a multiplicity of small, high aspect ratio depressions 15 and is free or substantially free of protrusions 20 above the plane 10 of the photopolymerizable surface. The matting agent is capable of forming the depressions into the surface of the photopolymerizable layer. The size of the depressions at the printing surface is distinguishable from the relief depth necessary for the printing element to function as a relief printing element by at least an order of magnitude. For example, for a plate of 67 mil (0.170 cm) nominal thickness, the depth of the depressions at the surface of the photopolymerizable layer from the plane of the layer is on the order of 2 to10 microns, whereas the relief depth of relief printing elements, such a flexographic printing plate, is on the order of 20 to 30 mils (508 to 762 microns).

The matting agent is capable of forming depressions from the plane 10 of the photopolymerizable layer and thus creates a topography of the printing surface which can be characterized by measurable properties that correlate to improved printing performance of the printing plate. The surface topography of the printing element or plate can be characterized by the following properties, and are schematically represented in FIGURES 1, 2, 3, and 4.

A "depression size" or "depression opening size", 25, is a measure of the depression opening at the surface of the photopolymerizable layer, measured parallel or substantially parallel to the plane 10 of the photopolymerizable layer. The depression size 25 may be described in multiple ways. The depression size 25 can be the size of the opening of the depression 15 expressed as a depression width, and can be either an average opening width or a maximum opening width. The depression size 25 can be the size of the opening of the depression expressed as a unit of area, e.g., square microns. The depression opening size 25 may also be expressed as a diameter of the size of the depression opening, (assuming a substantially round shape of the opening), or expressed as a radius.

A "depression depth" or "depression depth size", 30, and may also be referred to as "depression height", is the size of the depression into the photopolymerizable layer, measured perpendicular or substantially perpendicular to the plane of the photopolymerizable layer, from the surface of the photopolymerizable layer to the bottom of the depression 15. Depression depth 30 can be either an average depression depth or a maximum depression depth.

A "depression volume" is the depression opening size multiplied by the depression depth.

A "depression aspect ratio" is the ratio of the depression size opening width to the depression depth, in which both are in length units and expressed for example, as 0.5 to 1 or 1.5 to 1. The depression aspect ratio can be measured on an individual depression or can be expressed as a ratio of the average depression size opening width to the average depression depth for a measured region.

A "depression area coverage" is an amount of a unit surface area covered with depressions expressed in percent (%) area coverage (of the total area).

A "surface area" is the area of the surface of the photopolymerizable layer being measured, which may be expressed as square microns, or as a percent increase over unit surface area.

A "mean surface height", 35 is the average height of all surface pixels in a data set 40. The mean surface height represents a reference position from which surface characteristics, that is the depressions or protrusions, may be measured. The mean surface height 35 is a calculated value from surface analysis by an optical interferometer instrument. The mean surface height 35 is equal to the printing surface only when the printing surface exhibits no deviations in the height of its surface. If there are deviations in height of the printing surface, the mean surface height 35 will be different than the printing surface. The mean surface height 35 is influenced by the number of depressions 15 and/or protrusions 20 that exist in the surface of the photopolymerizable layer relative to the plane 10 of the photopolymerizable layer.

The "predetermined reference band" 45 is a selected value used to define the region of surface heights about the mean surface height 35 that is considered essentially flat, i.e., a range of depression depth sizes 30 at the surface of the photopolymerizable layer are considered nominally the same. An upper reference band 45a is defined as the selected value (arrow A) added to the mean surface height 35 and a lower reference band 45b is the selected value (arrow B) subtracted from the mean surface height 35.

A "surface peak" 50 is a surface element (i.e., surface protrusion 20) that extends above the mean surface height 35 plus the predefined reference band 45. Surface peaks 50 are surface elements that are above the mean surface height 35, specifically significantly enough above the mean surface height 35 as to also be above the upper reference band 45a. Depending on plate composition, manufacturing processes, surface roughness and reference band selection, various surface peaks 50 are below the plane 10 of the surface of the photopolymerizable layer. As such, surface peaks 50 are distinguishable from protrusions 20 above the plane 10 of the photopolymerizable layer, which can be provided by embossing, for example.

A "surface pit" 55 is a surface element (i.e., surface depression 15) that extends below the mean surface height 35 minus the predefined reference band 45. Surface pits 55 are surface elements that are below the mean surface height 35, specifically significantly enough below the mean surface height 35 as to also be below the lower reference band 45b.

A "surface pit frequency" or "surface pit density" is the number of surface pits per unit area. The surface pit frequency may be constrained by limits to the size of depressions 25 included in the measured region. It is possible to omit features measurable but effectively so small as to have minor physical significance to the surface topography. For example, surface depression openings 25 smaller than 0.5 square microns ($\mu^2$) may be omitted from the calculations.

An "average surface pit depth" is the average depth of all surface pits in a measured region of analysis, expressed in length units, e.g., microns. Unless otherwise indicated, the average surface pit depth includes the depressions 15 that are beyond the reference band 45b.

A "surface pit depth distribution" or "pit depth distribution" is a distribution of a frequency of the depth of the surface pits in a measured region of analysis. The pit depth distribution is count of the surface pits within a given range of depth of surface pits, for a number of ranges of surface pit depths, over a span of the depths measured for a given sample or measured region of analysis. Unless otherwise indicated, the surface pit depth distribution includes the depressions that exceed the reference band 45b.

A "pit to peak ratio" is the ratio of the number of surface pits to the number of surface peaks.

The flexographic printing plate made from the photosensitive element of the present invention has superior printing performance, in particular, improved solid ink density performance, dot gain performance, solid ink density uniformity and fine text quality. The flexographic printing plate achieves this superior performance through unique surface topography not shown in existing flexographic printing plates representing the current state of the art. The surface topography is characterized by a very high number of surface features, specifically small, deep (relative to their opening size) depressions 15, 55 in the printing surface of the printing plate. The depressions 15, 55 may also sharply transition from the opening at the surface to the depth of the depression. While the ' Applicants do not wish to be held to a particular theory, it is believed that this multiplicity of small, deep surface pits results in increased ink carrying capacity and improved ink release characteristics of the flexographic printing plate and thus improved transfer of ink from the printing plate to the printing substrate.

The surface topography of the flexographic printing element made from the photosensitive element is characterized by a very high number of surface pits 55 of significant depth such that, at least 40% of the overall printing surface is covered with surface pits, and generally between 40 to 60% of the overall printing surface is covered with surface pits. But also samples have been observed having greater than 60% of the printing surface being covered with surface pits 55. Further, the printing surface is free of or substantially free of surface peaks 50.

The surface topography includes surface pits 55 with a depression depth 30 greater than or equal to 2 microns at a frequency greater than about 80 pits per square millimeter, preferably at a frequency greater than about 100 pits per square millimeter, more preferably at a frequency greater than about 250 pits per square millimeter, and most preferably at a frequency greater than about 400 pits per square millimeter. Surface pits 55 with a depression depth 30 greater than or equal to 3 microns are present at a frequency greater than about 30 pits per square millimeter, preferably at a frequency greater than about 40 pits per square millimeter, more preferably are present at a frequency greater than about 80 pits per square millimeter, and most preferably at a frequency greater than about 150 pits per square millimeter. Surface pits 55 with a depression depth 30 greater than or equal to 4 microns are present at a frequency greater than about 10 pits per square millimeter, preferably at a frequency greater than about 30 pits per square millimeter, and more preferably are present at a frequency greater than about 50 pits per square millimeter. Surface pits 55 with a depression depth 30 greater than or equal to 5 microns are present at a frequency greater than about 1 pits per square millimeter, and preferably at a frequency greater than about 10 pits per square millimeter. For printing elements of the present invention, the surface pit frequency of surface pits 55 of all sizes (2 microns and deeper in size), can range from 350 to greater than 1000 pits per square millimeter, and up to 3000 pits per square millimeter.

Surface pit frequency is closely related to the depression area coverage, expressed as a percent. As the surface pit frequency increases, the average depression width size decreases. And at a given surface pit frequency, the average depression width size 25 increases as the percentage of depression area coverage increases. As the surface pit frequency and the percent depression area coverage increase, the average depression opening size 25 decreases. The average depression opening size 25 can be determined by the following relationship (formula I):

$$\frac{\text{Average Depression Area}}{\text{Opening Size}} = \left\{\frac{\text{Depression Area Coverage (in \%)}}{\text{Number of surface depressions (per unit area)}}\right\}$$

$$\text{(formula I)  Average Depression Opening Size } = 2 \times \text{ square root of } \left\{\frac{\text{Average Depression Area Opening Size}}{\pi}\right\}$$

In one embodiment, the depression area coverage is between 10 to 70 percent wherein the surface pit frequency is between 200 to 3000 pits per square millimeter which provides an average depression opening size 25 of between15 to 25 micron. In a second embodiment, the depression area coverage is between 10 and 40 percent wherein the surface pit frequency is between 200 to 3000 pits per square millimeter which provides an average depression opening size 25 of between 11 to 25 micron. And in a third embodiment, the depression area coverage is between 30 and 40 percent wherein the surface pit frequency is between 750 to about 3000 pits per square millimeter which provides an average depression opening size 25 of between 12 to 22 micron.

The depressions 15 and surface pits 55 are irregular in shape in the printing surface. The depressions 15 and surface pits 55 vary in opening size at the printing surface. In one embodiment, the depression opening width size 25 can range from about 5 microns to about 30 microns, and in a second embodiment the depression opening width size 25 is between 10 to 15 microns. The depression opening size 25 can include openings less than 5 micron width. Since multiple depressions can be formed in close proximity to each other, this may result in effectively larger depressions having an opening size 25 of about 40 microns or greater. Depression opening size 25 of about 40 microns or greater is not desirable since this results in reduced print quality

The depressions 15 vary in maximum depression depth 30 but are most commonly greater than 2 microns deep as measured from the top surface of the printing plate to the bottom of the depression. Although a significant number of depressions, i.e., greater than 100 depressions, are greater than 2 microns deep, in particular 15% of depressions or greater can be 3 microns deep, 5% or greater can be 4 microns deep an 1% and greater can be 5 microns deep.

The depression aspect ratio of the depression opening size 25 to the depression depth 30 can range from 10:1 1 to 2:1. An aspect ratio of 10:1 relates to surface pits where multiple particles have essentially joined to create a surface pit 55 that is large (e.g., 50 microns) but is relatively not deep, (e.g., 5 microns deep). Additionally, a single matting agent particle can create a surface pit, for example, which is 5 microns deep and 10 microns opening size. As such, it is also common to see aspect ratios of 2:1. All ratios in between 10:1 to 2:1 are possible.

Support

The support can be any flexible material which is conventionally used with photosensitive elements for use as flexographic printing plates and forms. Examples for suitable support materials include polymeric films such those formed by addition polymers and linear condensation polymers, transparent foams and fabrics, and metals such as aluminum. A preferred support is a polyester film; particularly preferred is polyethylene terephthalate. The support typically has a thickness from 0.001-0.030 inch. The support can also be any material suitable for use as a sleeve, or a cylindrical support, for the photopolymerizable layer.

Cover sheet

The photosensitive element optionally comprises a cover sheet as outermost protective layer on top of the matted layer or if present on top of the IR-sensitive layer. Useful cover sheets consist of flexible polymeric films, e.g., polyethylene terephthalate, which preferably is unsubbed but optionally may be subcoated with a thin silicone layer, polystyrene, polyethylene, polypropylene, or other strippable polymeric films. Preferably, polyethylene terephthalate is used.

Additional layers

Additional layers may be present disposed above the photopolymerizable layer. Suitable layers are those disclosed as elastomeric layers in the multilayer cover element described in US 4,427,759 and US 4,460,675. Such elastomeric layers comprise layers which are insensitive to actinic radiation themselves but become photosensitive when contacted with the photopolymerizable layer as well as such layers which are photosensitive themselves. These photosensitive elastomeric layers comprise preferably an elastomeric binder, a monomer, and a photoinitiator, and optionally fillers or other additives. Elastomeric layers which become photosensitive when contacted with the photopolymerizable layer do not comprise any monomer. Binder, monomer, and other compounds can be the same or similar to those compounds comprised in the photopolymerizable layer. These elastomeric layers are disposed between the photopolymerizable layer and the matted layer. In this case, a surface of the elastomeric layer opposite the photopolymerizable layer (and the support) defines the plane and the matting agent is capable of forming depressions from the plane into the elastomeric layer.

The photosensitive element can optionally include a wax layer as disclosed in U.S. Patent 6,673,509 disposed above the photopolymerizable layer. Suitable waxes are all natural and synthetic waxes, such as polyolefin waxes, paraffin waxes, carnauba waxes, stearin waxes, and steramide waxes. Preferred are waxes with a softening temperature $\geq$ 70 °C, especially polyethylene waxes having a softening temperature $\geq$ 90 °C. Conventional methods like casting, printing, or spray coating are used to prepare the wax layers from dispersions of the waxes in suitable solvents. The wax layer is usually 0.02-1.0 μm thick, preferably 0.05-0.5 μm. The wax layer can be between the matted layer and the photopolymerizable layer, or between the matted layer and the elastomeric layer if present. It is also contemplated that the matted layer can be between the wax layer and the photopolymerizable layer, or that the matting agent can be incorporated as part of the wax layer.

Furthermore, the photosensitive element may optionally comprise laser-radiation-sensitive layer that can form an integrated masking layer on the photosensitive element. A preferred laser-radiation- sensitive layer is sensitive to infrared (IR) laser radiation. In one embodiment, the laser-radiation-sensitive layer is an IR-sensitive layer that is removable during treating, i.e., soluble or dispersible in a developer solution or removable during thermal development; opaque to actinic radiation, i.e., ultraviolet or visible light, that is, has an optical density $\geq$ 2.5; and can be imaged with an infrared laser. The IR sensitive layer contains material having high infrared absorption in the wavelength range between 750 and 20,000 nm, such as, for example, polysubstituted phthalocyanine compounds, cyanine dyes, merocyanine dyes, etc., inorganic pigments, such as, for example, carbon black, graphite, chromium dioxide, etc., or metals, such as aluminum, copper, etc. The quantity of infrared absorbing material is usually 0.1-40 % by weight, relative to the total weight of the layer. To achieve the optical density of $\geq$ 2.5 to block actinic radiation, the infrared-sensitive layer contains a material that prevents the transmission of actinic radiation. This actinic radiation blocking material can be the same or different than the infrared absorbing material, and can be, for example, dyes or pigments, and in particular the aforesaid inorganic pigments. The quantity of this material is usually 1-70 % by weight relative to the total weight of the layer. The infrared-sensitive layer optionally includes a polymeric binder, such as, for example, nitrocellulose, homopolymers or copolymers of acrylates, methacrylates and styrenes, polyamides, polyvinyl alcohols, etc. Other auxiliary agents, such as plasticizers, coating aids, etc. are possible. In one embodiment, the infrared-sensitive layer is usually prepared by coating or printing a solution or dispersion of the aforesaid components on the cover sheet, and subsequently drying it before the matted layer is applied onto the cover sheet. The thickness of the infrared-sensitive layer is usually 2 nm to 50 μm, preferably 4 nm to 40 μm. These infrared-sensitive layers and their preparation are described in detail, for example in WO 94/03838 and WO 94/3839.

The matted layer generally can be in any position relative to the additional layers and the photopolymerizable layer. In a preferred embodiment, the matted layer is between the photopolymerizable layer (or the elastomeric layer if present) and any one or more of the other additional layers. The effect of the matte layer on the surface topography of the photopolymerizable layer (or the elastomeric layer) is enhanced when the matte layer is directly adjacent the surface of the photopolymerizable layer (or elastomeric layer). In one embodiment, the matted layer is between the photopolymerizable layer and the laser-radiation-sensitive layer. Alternatively, one or more additional layers can be between the matted layer and the photopolymerizable layer (or the elastomeric layer, if present). In this case, the effect of the matte layer on the surface topography of the photopolymerizable layer may be influenced by the thickness of the one or more additional layers, the size and/or composition of the matting agent particles, etc. It is also contemplated that the matting agent can be incorporated with the components of the additional layers to combine into one layer the function of the matting agent with the function of the additional layer on the photopolymerizable layer. Depending upon the components in the additional layer, the polymeric binder used with the matting agent (to form a separate matte layer) may not be needed or could be used instead of the film forming components in the additional layer.

The photosensitive element can optionally include an adhesive layer between the support and the photopolymerizable layer. Such adhesive materials are disclosed in US 3,036,913 or US 2,760,863. Alternatively, the support can have an adhesion promoting surface by flame-treatment or electron-treatment or the adhesion of the photopolymerizable layer to the support can be enhanced by exposure to actinic radiation through the support.

Furthermore, the photosensitive element can optionally include an antihalation layer between the support and the photopolymerizable layer. Such antihalation layer can be made by dispersing a finely divided dye or pigment which substantially absorbs actinic radiation in a solution or aqueous dispersion of a resin or polymer which is adherent to both the support and the photopolymerizable layer and coating it on the support and drying. Suitable antihalation pigments and dyes include carbon black, manganese dioxide, Acid Blue Black (CI 20470), and Acid Magenta O (CI 42685). Suitable polymeric or resin carriers include polyvinyl compounds, e.g., polyvinyl chloride homo- and copolymers, copolymers of acrylic and methacrylic acid, etc.

Process for preparing photosensitive elements

The present photosensitive element can be prepared by contacting the matted layer with one surface of a photopolymerizable layer. In one instance, the matted layer, is disposed on a cover sheet, and is then laminated onto the outermost surface of the element opposite the support, which is typically the photopolymerizable layer, with a conventional laminator. The photopolymerizable layer itself may be prepared in many ways by admixing the binder, monomer, initiator, and other ingredients and forming it into a sheet layer. It is preferred that the application of the matted layer onto the photopolymerizable layer is integrated within the usual production process of photosensitive elements for use as flexographic printing plates. Generally, the photopolymerizable mixture is formed into a hot melt and then calendered to the desired thickness. An extruder can be used to perform the function of melting, mixing, deaerating and filtering the composition. The extruded mixture is then calendered between the support and a cover element. Concerning the present invention, this cover element comprises a cover sheet, optionally an IR-sensitive layer, the matted layer, and optionally a wax layer and/or an elastomeric layer. Alternatively, the photopolymerizable material can be placed between the support and the cover element in a mold. The layers of material are then pressed flat by the application of heat and/or pressure. The combination of extrusion/calendering process is particularly preferred. After the photosensitive element is prepared, it is cooled, e.g., with blown air, and is passed under a bank of fluorescent lamps, e.g., black light tubes, placed traverse to the path of movement. The photosensitive element is continually exposed through the support to partially polymerize a predetermined thickness of the photopolymer layer adjacent the support.

Process for preparing flexographic printing plates

The photosensitive element produced as described above is then imagewise exposed by common processes through a photomask having areas transparent to actinic radiation and areas substantially opaque to actinic radiation. Actinic radiation means radiation that is capable of initiating photochemical reactions. Unless otherwise indicated for the photosensitive elements of the present invention, actinic radiation is ultraviolet and visible radiation. The photomask can be a separate film, i.e., an image-bearing transparency or phototool, such as a silver halide film; or can be the photomask integrated with the photosensitive element as described above. In the case in which the photomask is a separate film, the optional cover sheet is usually stripped before imagewise exposure leaving the matted layer on the photosensitive element. The photomask is brought into close contact with the matted layer of the photosensitive element by the usual vacuum processes, e.g., by use of a common vacuum frame. Thus a substantially uniform and complete contact between the matted layer and the photomask can be achieved in acceptable time.

In the case in which the photosensitive element includes a laser-radiation-sensitive layer, or the photosensitive element is part of an assemblage that includes a laser-radiation-sensitive layer, the laser-radiation sensitive layer is exposed to the appropriate laser radiation to form the photomask on the photosensitive element. In one embodiment, the laser-radiation sensitive layer contains a material having high absorption in the ultraviolet range between about 4 and 410 nm and is imagewise exposed to UV laser radiation to form an in-situ mask. In another embodiment, the laser-radiation sensitive layer the photosensitive element includes an IR-sensitive laver (or the matted laver also functions as the IR-sensitive layer), and the IR-sensitive layer is imagewise exposed to IR laser radiation to form the photomask on the photosensitive element. The infrared laser exposure can be carried out using various types of infrared lasers, which emit in the range 750 to 20,000 nm. Infrared lasers including, diode lasers emitting in the range 780 to 2,000 nm and Nd:YAG lasers emitting at 1064 nm are preferred. The radiation opaque layer is exposed imagewise to infrared laser radiation to form the image on or disposed above the photopolymerizable layer, i.e., the in-situ mask. The infrared laser radiation can selectively remove, e.g., ablate or vaporize, the infrared sensitive layer (i.e., radiation opaque layer) from the photopolymerizable layer, as disclosed by Fan in U.S. Patents 5,262,275; 5,719,009; 6,238,837; and 6,558,876. The integrated photomask remains on the photosensitive element for subsequent steps of overall exposure to actinic radiation and treating.

There are alternate methods of forming the integrated photomask on the photosensitive element. The photosensitive element does not initially include a laser-radiation-sensitive layer, for example, IR-sensitive layer. In this case, the infrared sensitive layer is the same as or substantially the same as the infrared sensitive layer included with the photopolymerizable layer as described above. A separate element bearing the infrared sensitive layer will form an assemblage with the photosensitive element such that the infrared sensitive layer is adjacent the surface of the photosensitive element opposite the support, which can be the matted layer (or the photopolymerizable layer). The separate element may include one or more other layers, such as ejection layers or heating layers, to aid in the process. The assemblage is exposed imagewise with infrared laser radiation to selectively transfer the infrared sensitive layer (with actinic radiation opaque material) and form the image on or disposed above the photopolymerizable layer as disclosed by Fan et al. in U.S. Patent 5,607,814; and Blanchett in U.S. Patents 5,766,819; 5,840,463; and EP 0 891 877 A. Only the portions of the infrared sensitive layer which were transferred will reside on the photosensitive element forming the in-situ mask.

For photosensitive elements having the integrated photomask, the imagewise exposure may be conducted in the presence or absence of atmospheric oxygen. In one embodiment, the imagewise exposure is conducted in the absence of atmospheric oxygen, for example, under vacuum, to minimize the effect of oxygen inhibiting polymerization. The matting agent can more fully realize its capability to form the depressions during imagewise exposure in the absence of atmospheric oxygen. In an another embodiment, the photosensitive element with the integrated photomask can be imagewise exposed in the presence of atmospheric oxygen and still retain the depressions after treating. In a further embodiment, the photosensitive element with the integrated photomask can be imagewise exposed in the presence of atmospheric oxygen and retain the depressions after treating when the photosensitive element further undergoes a pre-exposure to ultraviolet radiation between 200 and 300 nm (UV-C radiation), prior to the treating step. Preferably the pre-exposure radiation is between 245 and 265 nm, and most preferably 254 nm. The exposure time may vary from a few seconds to minutes depending upon the intensity and spectral energy distribution of the radiation. Typically, an exposure time of 3 to 15 minutes is used for UV-C energy of approximately 161 milli-joules /cm$^2$. The pre-exposure to UV-C can be before or after the main exposure to ultraviolet radiation between 310 and 400 nm (UV-A radiation). In one embodiment, the pre-exposure step to UV-C radiation is conducted after the main exposure to UV-A radiation, but can occur in the reverse order. Sources of UV-C radiation include, for example, low pressure mercury lamp, high-pressure mercury lamp, germicidal lamp, and heavy hydrogen lamp. In this case, because of the oxygen inhibiting effects associated with the main exposure in the presence of atmospheric oxygen, the UV-C pre-exposure cures the surface of the photopolymerizable layer to the extent that the depressions from the plane of the photopolymerizable layer are set in place before the element undergoes the treating step. If the photosensitive element with the integrated photomask is main exposed in the presence of atmospheric oxygen, and does not undergo the UV-C pre-exposure, the treating step can remove the unpolymerized areas, and thus can remove the surface topography formed by the matting agent. Upon imagewise exposure, the radiation-exposed areas of the photopolymerizable layer are converted to the insoluble state with no significant polymerization or crosslinking taking place in the unexposed areas of the layer. Any conventional source of actinic radiation can be used for this exposure. Examples of suitable radiation sources include xenon lamps, mercury vapor lamps, carbon arcs, argon glow lamps, fluorescent lamps with fluorescent materials emitting UV radiation and electron flash units, and photographic flood lamps. The most suitable sources of UV radiation are the mercury vapor lamps, particularly the sun lamps. The exposure time may vary from a few seconds to minutes, depending upon the intensity and spectral energy distribution of the radiation, its distance from the photosensitive element, and the nature and amount of the photopolymerizable material. While still providing suitable printing relief, it is possible that the photopolymerizable element may still be underexposed to the extent that the matting agent is limited in its capability to form the depressions on the printing surface. An overall back exposure may be conducted before or after the imagewise exposure to polymerize a predetermined thickness of the photopolymer layer adjacent the support. This polymerized portion of the photopolymer layer is designated a floor. The floor thickness varies with the time of exposure, exposure source, etc. This exposure may be done diffuse or directed. All radiation sources suitable for imagewise exposure may be used. The exposure is generally for 1-30 minutes.

Following overall exposure to UV radiation through the mask, the photosensitive printing element is treated to remove unpolymerized areas in the photopolymerizable layer and thereby form a relief image. The treating step removes at least the photopolymerizable layer in the areas which were not exposed to actinic radiation, i.e., the unexposed areas or uncured areas, of the photopolymerizable layer. The matted layer disposed above the non-exposed areas of the photopolymerizable layer and the polymeric binder of the matted layer which are disposed above the exposed areas of the photopolymerizable layer are removed with the treating step. It is possible that some of the matting agent may remain with the photopolymerized areas of the photopolymerizable layer. (In this case, the surface peaks above the plane of the photopolymerizable layer are created with both the matting agent and the photopolymerizable material. And thus are different from protrusions of photopolymeric material formed by embossing the photopolymerizable layer.) However, the essential effect is that matting agent has altered the surface topography of the printing surface of the flexographic printing plate by forming a multiplicity of high aspect ratio depressions in the surface from the plane of the photopolymerizable layer. Flexographic printing plates showing a high covering of the printing surface with the high aspect ratio of depressions can advantageously be used in some printing applications. Except for the elastomeric capping layer, typically the additional layers that may be present on the photopolymerizable layer are removed or substantially removed from the polymerized areas of the photopolymerizable layer. For photosensitive elements including a separate IR-sensitive layer for digital formation of the mask, the treating step also removes the mask image (which had been exposed to actinic radiation).

Treatment of the photosensitive printing element includes (1) "wet" development wherein the photopolymerizable layer is contacted with a suitable developer solution to washout unpolymerized areas and (2) "dry" development wherein the photosensitive element is heated to a development temperature which causes the unpolymerized areas of the photopolymerizable layer to melt or soften or flow and is wicked away by contact with an absorbent material. Dry development may also be called thermal development.

Wet development is usually carried out at about room temperature. The developers can be organic solvents, aqueous or semi-aqueous solutions, or water. The choice of the developer will depend primarily on the chemical nature of the photopolymerizable material to be removed. Suitable organic solvent developers include aromatic or aliphatic hydrocarbon, and aliphatic or aromatic halohydrocarbon solvents, for example, n-hexane, petrol ether, hydrated petrol oils, limonene or other terpenes or toluene, isopropyl benzene, etc., ketones such as methyl ethyl ketone, halogenated hydrocarbons such as chloroform, trichloroethane, or tetrachloroethylene, esters such as acetic acid or acetoacetic acid esters, or mixtures of such solvents with suitable alcohols. Other organic solvent developers have been disclosed in published German Application 38 28 551. Suitable semi-aqueous developers usually contain water and a water miscible organic solvent and an alkaline material. Suitable aqueous developers usually contain water and an alkaline material. Other suitable aqueous developer combinations are described in U.S. Patent No. 3,796,602. Additives such as surfactants or alcohols may be used.

Development time can vary, but it is preferably in the range of about 2 to about 25 minutes. Developer can be applied in any convenient manner, including immersion, spraying and brush or roller application. Brushing aids can be used to remove the unpolymerized portions of the element. Washout can be carried out in an automatic processing unit which uses developer and mechanical brushing action to remove the unexposed portions of the plate, leaving a relief constituting the exposed image and the floor.

Following treatment by developing in solution, the relief printing plates are generally blotted or wiped dry, and then more fully dried in a forced air or infrared oven. Drying times and temperatures may vary, however, typically the plate is dried for 60 to 200 minutes at 60°C. High temperatures are not recommended because the support can shrink and this can cause registration problems.

Treating the element thermally, i.e., dry development, includes heating the photosensitive element having at least one photopolymerizable layer (and the additional layer/s) to a temperature sufficient to cause the uncured portions of the photopolymerizable layer to soften or melt or flow, and contacting an outermost surface of the element to an absorbent surface to absorb or wick away the melt or flow portions. The polymerized areas of the photopolymerizable layer have a higher melting temperature than the unpolymerized areas and therefore do not melt, soften, or flow at the thermal development temperatures. Thermal development of photosensitive elements to form flexographic printing plates is described by Martens in U.S. Patents 5,015,556; 5,175,072; 5,215,859; and by Wang et al. in WO 98/13730.

The term "melt" is used to describe the behavior of the unirradiated portions of the photopolymerizable elastomeric layer subjected to an elevated temperature that softens and reduces the viscosity to permit flow and absorption by the absorbent material. The material of the meltable portion of the photopolymerizable layer is usually a viscoelastic material which does not have a sharp transition between a solid and a liquid, so the process functions to absorb the heated composition layer at any temperature above some threshold for absorption in the absorbent material. A wide temperature range may be utilized to "melt" the composition layer for the purposes of this invention. Absorption may be slower at lower temperatures and faster at higher temperatures during successful operation of the process.

The thermal treating steps of heating the photosensitive element and contacting an outermost surface of the element with an absorbent material can be done at the same time, or in sequence provided that the uncured portions of the photopolymerizable layer are still soft or in a melt state when contacted with the absorbent material. The at least one photopolymerizable layer (and the additional layer/s) are heated by conduction, convection, radiation, or other heating methods to a temperature sufficient to effect melting of the uncured portions but not so high as to effect distortion of the cured portions of the layer. The one or more additional layers disposed above the photopolymerizable layer may soften or melt or flow and be absorbed as well by the absorbent material. The photosensitive element is heated to a surface temperature above about 40 °C, preferably from about 40 °C to about 230 °C (104-446 °F) in order to effect melting or flowing of the uncured portions of the photopolymerizable layer. By maintaining more or less intimate contact of the absorbent material with the photopolymerizable layer that is molten in the uncured regions, a transfer of the uncured photosensitive material from the photopolymerizable layer to the absorbent material takes place. While still in the heated condition, the absorbent material is separated from the cured photopolymerizable layer in contact with the support layer to reveal the relief structure. A cycle of the steps of heating the photopolymerizable layer and contacting the molten (portions) layer with an absorbent material can be repeated as many times as necessary to adequately remove the uncured material and create sufficient relief depth. However, it is desirable to minimize the number of cycles for suitable system performance, and typically the photopolymerizable element is thermally treated for 5 to 15 cycles. Intimate contact of the absorbent material to the photopolymerizable layer (while in the uncured portions are melt) may be maintained by the pressing the layer and the absorbent material together.

A preferred apparatus to thermally develop the photosensitive element is disclosed by Peterson et at. in U. S. Patent 5,279,697, and also by Johnson et at. in Patent Cooperation Treaty Application No. PCT/US00/24400 filed September 6, 2000 (IM-1289 PCT). The photosensitive element may be placed on a drum or a planar surface in order for thermal treatment to be carried out.

The absorbent material is selected having a melt temperature exceeding the melt temperature of the uncured portions of the photopolymerizable layer and having good tear resistance at the same operating temperatures. Preferably, the selected material withstands the temperatures required to process the photosensitive element during heating. The absorbent material is selected from non-woven materials, paper stocks, fibrous woven material, open-celled foam materials, porous materials that contain more or less a substantial fraction of their included volume as void volume. The absorbent material can be in web or sheet form. The absorbent materials should also possess a high absorbency for the molten elastomeric composition as measured by the grams of elastomer that can be absorbed per square millimeter of the absorbent material. Preferred is a non-woven nylon web.

It is also contemplated that the photosensitive element may undergo one or more treating steps to sufficiently remove the uncured portions to form the relief. The photosensitive element may undergo both wet development and dry development, in any order, to form the relief. A pre-development treating step may be necessary to remove one or more of the additional layers disposed above the photopolymerizable layer if such additional layers are not removable by the washout solution and/or by heating.

The flexographic printing plate may be post exposed and/or chemically or physically after-treated in any sequence to detackify the surface of the flexographic printing plate.

EXAMPLES

The following examples illustrate the invention, but do not limit it. Unless otherwise indicated, the parts and percentages indicated refer to the weight.

In the following examples, CYREL® flexographic printing plates (including plates identified herein as DuPont types EXL, NOW, HiQ), CYREL® exposure unit, CYREL® processor, CYREL® FLEXOSOL® washout solvent, and CYREL® OPTISOL® washout solvent are products sold by E.I. du Pont de Nemours and Company, Wilmington, DE.

Procedure

Photosensitive elements were manufactured by the previously described process of extrusion and calendering a photopolymerizable composition into a layer between a support and a coversheet. For each of two types of plates by DuPont, a photosensitive element was made of a photopolymerizable composition between a conventional coversheet (polyester support with a release layer containing Macromelt® 6900 polyamide and an amphoteric interpolymer) and a support, and designated as NOW and HiQ. Similarly, a second photosensitive element was made with the same photopolymerizable composition between a matted coversheet (polyester support having a matted layer and a wax layer as described below) and a support, and designated as NOW-NS and HiQ-NS. DuPont plate types NOW, HiQ, EXL, and DPN each include a photopolymerizable composition comprised of at least one elastomeric binder, at least one ethylenically unsaturated compound photopolymerizable by actinic radiation, and at least one photoinitiator or photoinitiator system.

The matted coversheet was prepared as follows. A 100 μm thick polyester film was coated on one side with a matted layer consisting of 83 % by weight of a polyamide (Macromelt® 6900, from Henkel Corp.) and 17 % by weight of a porous silica (Syloid® ED-5 from Grace & Co., having a pore volume of 1.8 ml/g; oil number of 320 g/100 g; a BET surface of 380 m²/g; mean particle size of 5 μm (as measure by Coulter Counter method), particle size distribution of > 80 % within 2-25 μm). (The particle size and distribution of the porous silica, Syloid® ED-5, was also measured with a Mastersizer 2000 instrument (from Malvern Instruments, UK) in which case SYLOID ED-5 had a mean particle size of 9.44 μm, and had a distribution in which 98% or less (D98) of the particles were ≤ 22.63 microns, D90 were ≤17.25 micron, D50 were ≤9.44 micron, D10 were ≤4.73 micron, and D5 were ≤3.87 micron.) The matted layer having a dry coating weight of about 3.4 g/m². This matted layer was overcoated with a polyethylene wax layer having a coating weight of 0.8 mg/dm².

Process For Making a Printing Plate from A Photosensitive Element

The manufactured photosensitive elements were used and commercially-available photosensitive elements for flexographic printing as described below were purchased and were made into flexographic printing plates according to the following procedure. All of the photosensitive elements made and acquired were 67 mil thickness (0.17 cm). The elements were exposed to UV radiation on a CYREL ® 2001 E exposure unit. The photosensitive element was first exposed though the support to UV radiation of ~360 nm wavelength as described in the following table to polymerize the photopolymerizable layer forming a floor for the plate.

The coversheet was removed, and a photographic film mask was then brought in contact with the surface of the photopolymerizable layer opposite the support. The element and mask film combination were exposed in the exposure unit with vacuum wherein vacuum is drawn to provide intimate contact between the film mask and the surface of the photopolymerizable layer opposite the support. The film mask and photosensitive element combination was illuminated with UV radiation of ~354 nm wavelength as described in the following table to imagewise polymerize the photopolymerizable layer of the element. After which, the film mask was removed from the element.

The exposed element was placed in a CYREL® 10011P plate processing device whereupon the plate was treated with OPTISOLOL® washout solution with agitation at 38°C, for 6 minute residence time. This process removed unpolymerized areas from the photopolymerizable layer of the element and the polymerized areas remain forming an imagewise relief structure useful as a flexographic printing plate. The processed flexographic printing was then dried in a CYREL® 2001 LF drying oven where heated forced air was blown over the printing plate at 60 °C for 120 minutes, sufficient to remove substantially all excess and absorbed solvents to a point where the plate is suitably dry and dimensionally stable.

The dried flexographic printing plate was then post-exposed and finished duration to ensure complete polymerization of the layer and surface. The plate was exposed in the CYREL® 2001 LF exposure device to UV radiation of -350 nm and 254 nm as described in the table below. The element was ready for use as a flexographic printing plate.

| | Back Exposure | Main Exposure | Post Exposure | Light Finishing |
|---|---|---|---|---|
| | (Seconds) | (Minutes) | (Minutes) | (Minutes) |
| DuPont EXL | 20 - 32 | 9 - 16 | 8 - 12 | 15-25 |
| DuPont NOW and NOW-NS | 150 - 200 | 5 - 30 | 8 - 12 | 8-12 |
| DuPont HiQ-NS | 100-140 | 5-15 | 3-7 | 3-7 |
| MacDermid ULT | 30 - 60 | 5 - 23 | 8 - 12 | 6 - 8 |
| MacDermid Encore | 45 - 75 | 6 - 28 | 8 - 12 | 5 - 7 |
| MacDermid Epic | 20 - 30 | 7 - 35 | 8 - 12 | 8-12 |
| MacDermid Epic QI | 40 - 60 | 3 - 12 | 8 - 12 | 8-12 |
| Asahi SH | 40-70 | 10-20 | 3-7 | 4-10 |

(continued)

|  | Back Exposure | Main Exposure | Post Exposure | Light Finishing |
|---|---|---|---|---|
|  | (Seconds) | (Minutes) | (Minutes) | (Minutes) |
| _Asahi HD | 45-85 | 10-20 | 3-7 | 4-10 |
| BASF ACE | 140 - 200 | 10 - 20 | 3 - 7 | 4-10 |

Process for Printing With The Printing Plate

The flexographic printing plate was cut to the appropriate size, and mounted using 3M 1020 flexographic mounting tapes to a printing form cylinder of an IGT F1 Printability Tester device (manufactured by IGT, Amsterdam, Netherlands). The printing form cylinder was mounted on press. An anilox roller of 5.2 BCMI pore volume and 180 line/ cm pore density was mounted on press. A printing substrate, 2.4 mil white polyethylene, was loaded on tester device. Press conditions were established by modifying digital settings per manufacturer's instructions. Specific settings for the device used were 50 Newton anilox roller to flexographic plate pressure (anilox pressure), 50 Newton print impression roller to flexographic printing plate pressure (impression pressure), and 0.30 meter/second print speed, unless otherwise indicated. The inking system was charged with ink that was SunSharp Process Cyan ink. The printing process was initiated resulting in a quantity of ink being deposited on the anilox roller, transferred to the printing plate and further transferred to the printing substrate resulting in a printed test form.

Analysis of Printed Test Form

The printed test form may contain any number and type of graphic elements as defined by the photographic film mask during exposure. For the printing tests conducted the printed test form contained image elements suitable for analysis of critical print performance attributes including but not limited to tint values for assessment of dot gain, solid print regions for assessment of solid density and print uniformity, positive and negative line elements for assessment of line quality, positive and negative text elements for assessment of text quality. Printed tests forms were then evaluated using common techniques familiar to those skilled in the art including but not limited to the measurement of density in solid regions, measurement of density in tint regions, assessment of solid density regions for uniformity via granularity and mottle measurements and subjective text print quality analysis.

Densitomteric analysis was measured on a Gretag D183 reflection densitometers (manufactured by GretagMacbeth, Little Windsor NY). Graininess and mottle measurements were measured on the Personal IAS (Image Analysis System) manufactured by Quality Engineering Associates of Burlington, MA.

"Density" is the log (1 / Transmittance)

wherein transmittance, T, is

$$T= (\text{light reflected (or transmitted)}) / (\text{light incident})$$

"Dot area" or "effective dot area" is

$$[1-10^{(-Dt)}] / [1-10^{(-Ds)}]$$

where

Ds is the density of solid area, and

Dt is the density of tint region

"Mottle" and "Graininess" are each a measurement of the density of an image area of solid ink laydown, wherein a printing element having an image of a solid ink area has printed onto a substrate. The printed image of solid ink coverage is digitally captured as grey scale values, and the image is broken into tiles of 250 microns by 250 microns. "Mottle" is the standard deviation of the density (reflectance) values tile to tile. "Graininess" is the standard deviation of the density (reflectance) values within a tile.

Analysis of Plate Surface Characteristics

Flexographic printing plate surface characteristics were assessed using a variety of methods including conventional optical microscopy, SEM analysis, surface profilimetery and optical interferometry.

The optical interferometer used was a Zygo NewView 5000 equipped with a 50X objective providing a field of view of 144 microns by 107 microns. The interferometer was equipped with a noise filter designated F2. Data analysis was conducted using Zygo MetroPro Analysis Software version 7.9.0. Equipment and software manufactured by Zygo Corporation, Middlefield, CT.

The optical microscope used is a Nikon Measurescope (Nikon USA, Melville NY) equipped with a 20X objective, Sony CCD IRIS Color Digital Camera and Metronics Quadra Check 2000 measurement system (Metronics Inc., Bedford NH).

The surface roughness, Ra and Rq, were measured according to ISO 4287 and DIN 4768, on a Tencor Alpha-step profilometer.

Example 1

Samples of the plates where tested for surface topography characteristics of the printing surface as described above. The results are presented in Table 1 and Table 2. The results are based upon optical interferometry measurement using a 2 micron reference band width, i.e., 1 micron upper reference band and 1 micron lower reference band about the mean surface height; and where depressions or surface pits less than 2 square microns in surface area are excluded from the calculations.

It should be noted that additional analysis conditions were evaluated including changes to the reference band width specifically to values of 1 (plus or minus 0.5 microns about the mean surface height), 2 (plus or minus 1 micron about the mean surface height) and 3 (plus or minus 1.5 microns about the mean surface height) as well as minimum peak and pit areas of 1 and 2 square microns. Under all analysis conditions, the relative number of surface pits for all samples remained the same.

In Table 1, the number of surface pits was determined by physically counting the number of depressions, i. e., the number of dark gray spots, from an image of the surface of the plate sample taken by the optical interferometer. In Table 2, the % of total surface pits by size was determined by MetroPro Analysis software on the optical interferometer as described above.

TABLE 1

| Example | Plate Material | Surface Peaks | Surface Pits | Surface Pit Density | Ra | Rg |
|---|---|---|---|---|---|---|
| | | # | # | #/mm$^2$ | Microns | Microns |
| Example 1A | NOW-NS | 15-30 | >280 | >1000 | 1.27 | 1.7 |
| Example 1B | HiQ-NS | 10-25 | 100 - 300 | 350 - >1000 | .76 - 1.2 | 1.0-1.5 |
| Comparative Ex. 1A | MacDermid Epic | 85 | 51 | 187 | 0.422 | 0.673 |
| Comparative Ex. 1B | DuPont EXL | 14 | 13 | 48 | 0.387 | 0.538 |
| Comparative Ex. 1C | BASF Ace | 0 | 13 | 48 | 0.475 | 0.59 |
| Comparative Ex. 1D | MacDermid Encore | 2 | 12 | 44 | 0.464 | 0.75 |
| Comparative Ex. 1E | MacDermid ULT | 0 | 10 | 37 | 0.461 | 0.66 |
| Comparative Ex. 1F (Control) | DuPont NOW | 0 | 0 | 0 | 0.358 | 0.451 |
| Comparative Ex. 1G | Epic QI | 0 | 0 | 0 | 0.502 | 0.644 |
| Comparative Ex. 1H | Asahi HD | 0 | 0 | 0 | 0.47 | 0.57 |
| Comparative Ex. 1J | Asahi SH | 0 | 0 | 0 | 0.414 | 0.515 |
| Example 1A-a* | NOW-NS Exposed, release layer removed | 34 | 291 | 1069 | 1.172 | 1.644 |

*For Example 1A-a the plate was backflashed, the coversheet removed, main exposed, then the release layer was removed by hand. The plate was not washed out. The surface of the photopolymerizable layer that was adjacent to the matted release layer (before being removed) was tested.

*For Example 1A-b the plate was backflashed, the coversheet removed, and main exposed. The surface of the plate adjacent to the coversheet, i.e., the surface of the matted layer opposite the photopolymerizable layer, was tested.

*For Example 1A-c and Comparative Ex. 1 K, the plate's coversheet was removed, but the plate was not exposed or treated by wash out. The surface of the plate adjacent to the coversheet, i.e., the surface of the release layer opposite the photopolymerizable layer, was tested.

TABLE 1 (continued)

| Example | Plate Material | Surface Peaks | Surface Pits | Surface Pit Density | Ra | Rg |
|---|---|---|---|---|---|---|
| | | # | # | #/mm$^2$ | Microns | Microns |
| Example 1A-b* | NOW-NS Exposed, with matted layer | 0 | 0 | 0 | 0.284 | 0.352 |
| Comparative Ex. 1 K* | NOW Unexposed, no Coversheet | 0 | 0 | 0 | 0.086 | 0.146 |
| Example 1A-c* | NOW-NS Unexposed, no Coversheet | 0 | 0 | 0 | 0.072 | 0.108 |

*For Example 1A-a the plate was backflashed, the coversheet removed, main exposed, then the release layer was removed by hand. The plate was not washed out. The surface of the photopolymerizable layer that was adjacent to the matted release layer (before being removed) was tested.

*For Example 1A-b the plate was backflashed, the coversheet removed, and main exposed. The surface of the plate adjacent to the coversheet, i.e., the surface of the matted layer opposite the photopolymerizable layer, was tested.

*For Example 1A-c and Comparative Ex. 1 K, the plate's coversheet was removed, but the plate was not exposed or treated by wash out. The surface of the plate adjacent to the coversheet, i.e., the surface of the release layer opposite the photopolymerizable layer, was tested.

TABLE 2

| Example | Plate Material | % Area Coverage of Surface Depression | % of total Surface Pits ≥ 2 Microns | % of total Surface Pits ≥ 3 Microns | % of total Surface Pits ≥ 4 Microns | % of total Surface Pits ≥ 5 Microns | Number of Surface Pits ≥ 2 Microns per Square mm | Number of Surface Pits ≥ 3 Microns per Square mm | Number of Surface Pits ≥ 4 Microns per Square mm | Number of Surface Pits ≥ 5 Microns per Square mm |
|---|---|---|---|---|---|---|---|---|---|---|
| | | | % | % | % | % | Count | Count | Count | Count |
| Example 1A | NOW-NS | 36.1 | 45.0% | 14.6% | 5.1% | 1.3% | >450 | >150 | >50 | >10 |
| Example 1B | HiQ-NS | 18.4 | 25-40% | 8-13.5% | 2-5% | 0.0% | 90 - 400 | 40 - 150 | 10-50 | 0 - 10 |
| Comparative Ex. 1A | MacDermid Epic | 7.3 | 33.3% | 0.0% | 0.0% | 0.0% | 62 | 0 | 0 | 0 |
| Comparative Ex. 1B | DuPont EXL | 4.8 | 0.0% | 0.0% | 0.0% | 0.0% | 0 | 0 | 0 | 0 |
| Comparative Ex. 1C | BASF Ace | 2.1 | 30.8% | 0.0% | 0.0% | 0.0% | 15 | 0 | 0 | 0 |
| Comparative Ex. 1D | MacDermid Encore | 5.2 | 50.0% | 16.7% | 16.7% | 8.3% | 22 | 7 | 7 | 4 |
| Comparative Ex. 1E | MacDermid ULT | NM* | 60.0% | 0.0% | 0.0% | 0.0% | 22 | 0 | 0 | 0 |
| Comparative Ex. 1F (Control) | DuPont NOW | 0.7 | 0.0% | 0.0% | 0.0% | 0.0% | 0 | 0 | 0 | 0 |
| Comparative Ex. 1G | Epic QI | NM | 0.0% | 0.0% | 0.0% | 0.0% | 0 | 0 | 0 | 0 |
| Comparative Ex. 1H | Asahi HD | NM | 0.0% | 0.0% | 0.0% | 0.0% | 0 | 0 | 0 | 0 |
| Comparative Ex. 1J | Asahi SH | NM | 0.0% | 0.0% | 0.0% | 0.0% | 0 | 0 | 0 | 0 |
| Example 1A-a* | NOW-NS Exposed, release layer Removed | NM | 46.0% | 14.8% | 3.8% | 1.0% | 492 | 158 | 41 | 11 |

EP 1 457 823 A2

EP 1 457 823 A2

| Example | Plate Material | % Area Cover-age of Surface Depress-ion | % of total Surface Pits ≥ 2 Microns | % of total Surface Pits ≥ 3 Microns | % of total Surface Pits ≥ 4 Microns | % of total Surface Pits ≥ 5 Microns | Number of Surface Pits ≥ 2 Microns per Square mm | Number of Surface Pits ≥ 3 Microns per Square mm | Number of Surface Pits ≥ 4 Microns per Square mm | Number of Surface Pits ≥ 5 Microns per Square mm |
|---|---|---|---|---|---|---|---|---|---|---|
| Example 1A-b* | NOW-NS Exposed, with matted layer | NM | 0.0% | 0.0% | 0.0% | 0.0% | 0 | 0 | 0 | 0 |
| Comparative Ex. 1K* | NOW Unexposed , no Coversheet | NM | 0.0% | 0.0% | 0.0% | 0.0% | 0 | 0 | 0 | 0 |
| Example 1A-c* | NOW-NS Unexposed , no Coversheet | NM | 0.0% | 0.0% | 0.0% | 0.0% | 0 | 0 | 0 | 0 |

*For Example 1A-a the plate was backflashed, the coversheet removed, main exposed, then the release layer was removed by hand. The plate was not washed out. The surface of the photopolymerizable layer that was adjacent to the matted release layer (before being removed) was tested.

*For Example 1A-b the plate was backflashed, the coversheet removed, and main exposed. The surface of the plate adjacent to the coversheet, i.e., the surface of the matted layer opposite the photopolymerizable layer, was tested.

*For Example 1A-c and Comparative Ex. 1K, the plate's coversheet was removed, but the plate was not exposed or treated by wash out. The surface of the plate adjacent to the coversheet, i.e., the surface of the release layer opposite the photopolymerizable layer, was tested.

*NM= Not measured

Note % Area Coverage of Surface Depressions was determined by the optical profilimetery method by capturing grayscale image and evaluated using software analysis as described in Example 4.

The presence of the surface depressions result in a printing surface that is characterized by a moderately rough surface region populated with a very high number of relatively deep depressions and is considered significantly different from the printing surface of flexographic printing plates in the prior art.

Printing plates of the prior art may be (1) plates having a printing surface characterized by no distinct surface peaks or surface pits, that is considered flat or substantially flat, as shown in Comparative Examples 1 F through 1 J; (2) plates having a printing surface characterized by both a number of small surface peaks and surface pits in roughly equal proportions, as shown in Comparative Examples 1A through 1B; (3) plates having a printing surface with discontinuities, that is, plates having a printing surface characterized by large regions that are flat, i.e., have no distinct surface peaks or surface pits, but contains a small number of surface elements which may be surface peaks above the flat surface or surface pits below the flat surface that in total cover a small percentage of the overall surface area, as shown in Comparative Examples 1 C through 1 E.

EXAMPLE 2

Samples of a photosensitive element according to the present invention and a comparative were evaluated for printing performance produced under a variety of printing conditions (varying anilox pressure, print pressure, and print speed). A photosensitive element having a matted layer that was prepared as described above in Example 1, on a photopolymerizable layer of a CYREL® HiQ flexographic printing plate, designated as HiQ-NS, was prepared. As a comparative, a commercially-available CYREL® HiQ flexographic printing plate (having no matting agent in a release layer) was used. Both elements were exposed and treated as described above. Samples were cut from each printing element and printed on the IGT F1 Printability Tester device at the same conditions and the printing performance evaluated and presented in the following Table- Test 1. Evaluation of type (Pos Type and Neg Type) conducted subjectively with printing samples rated from 1 (best) to 3 (worst).

## Table- Test 1

| Run Order | Impress Pressure | Anilox Pressure | Speed | Example 2 (HiQ-NS) | | | Comparative Exam. 2 (HiQ) | | |
|---|---|---|---|---|---|---|---|---|---|
| | | | | Density | Pos Type *1 | Neg Type *2 | Density | Pos Type *1 | Neg Type *2 |
| 1 | 200 | 100 | 0.5 | 1.30 | 3 | 3 | 1.06 | 3 | 3 |
| 2 | 100 | 100 | 0.4 | 1.41 | 1 | 2 | 1.32 | 2 | 3 |
| 3 | 100 | 50 | 0.3 | 1.52 | 2 | 1 | 1.44 | 2 | 2 |
| 4 | 200 | 150 | 0.4 | 1.53 | 3 | 3 | 1.35 | 2 | 3 |
| 5 | 200 | 50 | 0.4 | 1.52 | 2 | 2 | 1.32 | 3 | 3 |
| 6 | 50 | 150 | 0.4 | 1.48 | 1 | 3 | 1.27 | 3 | 2 |
| 7 | 100 | 50 | 0.5 | no data | 1 | 2 | 1.11 | 3 | 2 |
| 8 | 50 | 100 | 0.5 | 1.42 | 1 | 1 | 1.05 | 3 | 2 |
| 9 | 100 | 150 | 0.5 | 1.43 | 1 | 2 | 1.10 | 2 | 2 |
| 10 | 50 | 50 | 0.4 | 1.42 | 1 | 1 | 1.27 | 2 | 2 |
| 11 | 100 | 100 | 0.4 | 1.50 | 1 | 2 | 1.34 | 2 | 3 |
| 12 | 50 | 100 | 0.3 | 1.49 | 1 | 2 | 1.38 | 2 | 2 |
| 13 | 200 | 100 | 0.3 | 1.50 | 3 | 2 | 1.43 | 3 | 3 |
| 14 | 100 | 150 | 0.3 | 1.48 | 1 | 3 | 1.42 | 2 | 2 |
| 15 | 100 | 100 | 0.4 | 1.37 | 1 | 2 | 1.33 | 3 | 2 |

*1 Pos Type is positive reading type (dark letters on a white background).
*2 Neg Type is negative reading type (light letters on a printed background).

The results demonstrated that under all printing conditions, the HiQ-NS plate samples produced significantly higher solid ink density results. Also, under most print conditions the HiQ-NS plate samples produced better print quality as evaluated by both positive and negative line qualities.

EXAMPLE 3

The plates prepared according to Example 1 were evaluated for printing performance as characterized by mottle and graininess. Test 2 compares the density uniformity results that were achieved with plates having different surface structures.

## Test 2: Comparison of Various Plate Products

|  |  | Graininess | Mottle |
|---|---|---|---|
| Example 1A | NOW-NS | 1.93 | 0.74 |
| Comparative Ex. 1G | Epic QI | 2.37 | 0.91 |
| Comparative Ex. 1F | NOW | 2.78 | 0.86 |
| Comparative Ex. 1C | BASF - ACE | 3.01 | 1.25 |

The results demonstrated that for both the graininess and mottle measurements, the NOW-NS plates resulted in the lowest graininess and mottle indicating more uniform solid ink density laydown. These results also correlated with physical observations of the print samples as can be observed in the images provided in Figures 5a, 5b, 5c, and 5d. Figure 5a was a printed image provided by the plate of Example 1A. Figure 5b was a printed image provided by the plate of Comparative Example 1G. Figure 5c was a printed image provided by the plate of Comparative Example 1 F. Figure 5d was a printed image provided by the plate of Comparative Example 1 C.

Test 3 was an assessment of the dot gain performance of a printing plate having the matted layer and therefore has surface topography of the printing surface according to the present invention, relative to two other plates with different surface characteristics. The results are presented in Table - Test 3.

## Table - Test 3

|  |  | 10% Dot Area | 25% Dot Area | 50% Dot Area |
|---|---|---|---|---|
| Example 1A | NOW-NS | 50.3% | 75.5% | 92.1% |
| Comparative Ex. 1G | EPIC-QI | 52.0% | 81.4% | 93.8% |
| Comparative Ex. 1B | EXL | 60.5% | 87.0% | 96.3% |

This test demonstrated the improvement that can be observed in dot gain (lower dot area numbers represent lower dot gain and are considered an improved result) across a range of dot areas.

EXAMPLE 4

The following Example demonstrates the effect of different levels of depression area coverage relative to printing performance as characterized by density and graininess.

All samples for Example 4 were prepared from CYREL® type NOW flexographic printing plates in which the coversheet and release layer were removed and replaced with a layer of a matte composition described as follows. All samples were exposed and processed according to the conditions described above to produce a printing form suitable for print testing as described above.

For all samples the plate surface topography was evaluated utilizing optical profilimetery which captured a grayscale image of the plate surface wherein gray levels are representative of surface profile depth. The lightest gray values represented the tallest (highest) features of the surface and the darkest gray values represented the lowest features, i.e., depressions, of the surface. Grayscale images were evaluated in Adobe Photoshop 7.0.1 (Adobe Systems Incorporated, 345 Park Avenue, San Jose, CA 95110, 408-536-6000) by importing each surface image, converting to a grayscale in Photoshop, posterizing to five gray levels and calculating the percentage of number of pixels having the two darkest gray levels (that is, gray scale values less than or equal to 63) relative to the total number of pixels in the image, as representing the percent coverage of surface depressions. A census of the surface depressions was also conducted by the test method described above. The results are presented in the following Table.

For Example 4A, a matted cover sheet material was prepared from by coating a polyester film on one side to form a layer of a matte composition from a coating solution consisting of 86% by weight of a polyamide (Macromelt® 6900) and 14% by weight of a matting agent (as described in Example 1, having a mean particle size of 9 micron). The matted layer had a dry coating weight of 20 mg/square decimeter.

Example 4A had an average of 14% of the surface area covered with depressions (i.e., depression area coverage) and a surface pit density of 1140 pits per square millimeter. Print results indicated a significant improvement in solid ink density achieved and a reduction in density graininess when compared to Example 4D.

Example 4B

Example 4B was prepared and analyzed in the same manner as Example 4A, except that the silica matting agent was present at 20% by weight in the coating solution.

Example 4C:

Example 4C was prepared and analyzed in the same manner as Example 4B except the coating solution was coated at 33 mg/square decimeter.

Example 4D

Example 4D was a control which was prepared and analyzed in the same manner as Example 4A above except there was no matting agent present in the coating solution.

|  | % Surface Pits | Number of Pits | Density | Graininess |
|---|---|---|---|---|
| Example 4A | 14% | 1140 | 1.70 | 1.30 |
| Example 48 | 21 % | 1710 | 1.70 | 1.29 |
| Example 4C | 37% | 2140 | 1.65 | 1.38 |
| Example 4D | 0% | 0 | 1.54 | 1.97 |

For each of the Examples 4A, 4B, and 4C representing different levels of depression area coverage, the solid ink density was improved when compared to the solid ink density of Example 4D, which had no matte and thus no depressions. The solid ink uniformity of each of Examples 4A, 4B, and 4C was similarly improved when compared to the same for Example 4D. (The lower graininess number indicates a more uniform ink laydown on the printed substrate.)

EXAMPLE 5

The following example demonstrates a method of this invention in which a printing form retained the surface topography of depressions from the plane into the photopolymerizable layer formed by the matting agent by exposing the photopolymerizable layer to ultraviolet radiation at about 254 nm prior to the treating step.

A photosensitive element for Example 5 having a matte layer on the photopolymerizable layer was prepared from a CYREL® type NOW printing plate. The coversheet and release layer were removed from the NOW plate and replaced with the matted coversheet as described in Example 1.

The element was back exposed through the support side to ultraviolet radiation at 354nm for 160 seconds to form a floor. The coversheet was removed and the side of the element opposite the support was main exposed to ultraviolet radiation at 354nm for about 8 minutes in the presence of atmospheric oxygen. No target or phototool was used during the main exposure step and as such vacuum was not necessary. Half of the element was covered with an ultraviolet radiation blocking sheet on the side opposite the support. The element (uncovered half) was then exposed to ultraviolet radiation at 254 nm for 10 minutes in a CYREL Light Finishing Unit.

The exposed element was treated in a CYREL 1000P plate processor and washed with Optisol® washout solution at 38°C for 5 minutes to removed unexposed areas and form a relief surface for a printing plate. The plate was dried in a CYREL 2001 oven at 60°C for 120 minutes, post-exposed to ultraviolet radiation at 350nm for 5 minutes and given a finishing exposure to ultraviolet radiation at 254 nm for 10 minutes.

Micrographs of the plate surface at each of the covered and uncovered portions of the plate (for the first 254 nm exposure) were taken with an OptiPhot microscope, model 237551 (by Nikon), at 20X magnification. FIGURE 6 is a representation of the micrograph that shows a side-by-side comparison of the surface of the plate between those portions which were blocked with the first 254 nm exposure (arrow A) and those portions which were exposed from the first 254 nm exposure (arrow B). The side-by-side micrograph showed that the portion of the plate that was covered (indicated by arrow A) during the first 254 nm exposure before solvent processing (that is, a pre-finishing exposure), lost much if not all, of the topography at the surface created by the matting agent, that is, the surface had no or minimal depression from the plane of the surface of the photopolymerizable layer. The surface indicated by arrow A looked smooth and was a couple of microns thinner than the surface indicated by arrow B. The portion of the plate that was not covered (indicated by arrow B) and therefor given the first 254nm exposure before solvent processing, retained the topography at the surface created by the matting agent, that is, the surface had depressions from the plane of the surface of the photopolymerizable layer.

This example showed that main exposure in the presence of atmospheric oxygen can influence the effect of forming depressions from the plane of the photopolymerizable layer by the matting agent. Also, this example showed that a pre-finishing exposure at 254 nm retained the surface topography of depressions from the plane into the photopolymerizable layer formed by the matting agent.

It is expected that the surface topography of depressions below the surface of the plane of the photopolymerizable layer can be better retained in a photosensitive element that includes photopolymerizable layer, an in-situ mask and a layer of matting agent, provided that the element undergoes an exposure at 254 nm before treatment to form the relief.

EXAMPLE 6

A photosensitive element was manufactured by the previously described process of extrusion and calendering a photopolymerizable composition into a layer between a support and a coversheet. The Comparative element was a CYREL® type DPN flexographic printing plate (67 mil), having an infrared laser radiation sensitive layer comprising 67% by weight Macromelt® polyamide and 33% by weight carbon black, and a layer of polyethylene wax adjacent the photopolymerizable layer opposite the support. The DPN photopolymerizable layer included at least one elastomeric binder, at least one ethylenically unsaturated compound photopolymerizable by actinic radiation, at least one photoinitiator or photoinitiator system and additives. The structure of the Comparative element was, in order, a support, the photopolymerizable layer, the wax layer, infrared sensitive layer, and coversheet. The photosensitive element of Example 6 had a photopolymerizable layer that was the same composition as the photopolymerizable layer in CYREL® type DPN flexographic printing plate. The photopolymerizable layer was formed between a support and a matted coversheet. The matted layer was prepared and coated as described in Example 1, except that a polyurethane binder (Neorez R-563 from Neoresins, The Netherlands) was used. An infrared radiation sensitive layer as described for the DPN plate was also included with the coversheet. The structure of the element for Example 6 was, in order, the support, the photopolymerizable layer, the matted layer, the infrared-radiation sensitive layer, and a coversheet. The matted layer had a total coating wt. of 9 mg/dm$^2$ comprising of a silica matting agent Syloid ED-5 at a coating wt. of 1.8 mg/dm$^2$.

After discarding the coversheet, each element was mounted on the drum of the CYREL® Digital Imager with the infrared-radiation sensitive layer facing out, and the element was held tight with vacuum on the drum and with tapes on all sides. Artwork images (containing solid areas, screened dot areas, text and line elements) were laser ablated onto the radiation opaque layer using Nd:YAG laser (light wavelength output at 1064 nm). An *in situ* mask on the element was obtained with the laser ablation energy of 3.5 Joules/cm$^2$. The ablated elements were given a back exposure of 65 sec and a main UV exposure in the open air (under atmospheric oxygen) for 7 minutes on a Exposure Unit 4260 Expo LF (from Degraf, 1-20084 Lacchiarella, Milan/Italy). The imaged elements were washed out with Flexosol® at 30 degree Celsius for 7 min in a CYREL® Smart XL processor, then dried for 180 min at 60 degree Celsius in a CYREL® 1002D Dryer and finished with UV-C for 7 min in a CYREL® 1002F Finisher unit. Printing elements with a relief depth of 0.95 mm were obtained.

The elements were printed on a LEMO "Meisterflex" printing press (from LEMO Maschinenbau GmbH, D-53859 Niederkassel-Mondorf/Germany) at 120 meters/minute. The substrate was a polyethylene foil (55 micron, 400 mm width). The ink used was a solvent-based ink ZPEA HOKO Magenta (from Siegwerk Druckfarben AG, D-53721 Siegburg/Germany) with an ink viscosity of 27 sec measured with a 4 mm efflux cup. The anilox roll used was 320 l/cm, with 4.0 cm$^3$/m$^2$ at 60 degree angular position. The substrate was printed at several impression settings at 90 micron, 120 micron and 150 micron.

The element of Example 6 with the matted layer had improved print performance compared to the Comparative example. The optical density of the printed solids was measured with a Gretag-Macbeth D19C densitometer (from Gretag-Macbeth AG, CH-8105 Regensdorf/Switzerland). The element of Example 6 with the matted layer had much higher solid ink density at 1.64 than the Comparative element at 1.50 (measured for 90 micron impression). The dot shape and reverses printed by Example 6 were equivalent to the Comparative example.

**Claims**

1. A photosensitive element for use as a flexographic printing plate comprising

   a) a support,
   b) at least one elastomeric photopolymerizable layer on the support containing at least one elastomeric binder, at least one ethylenically unsaturated compound photopolymerizable by actinic radiation, and at least one photoinitiator or photoinitiator system, the elastomeric photopolymerizable layer having a surface opposite the support that defines a plane; and
   c) a matted layer disposed above the surface of the photopolymerizable layer comprising a polymeric binder and at least one matting agent, the at least one matting agent capable of forming depressions from the plane into the photopolymerizable layer, and selected from the group consisting of

   i) matting agents having a pore volume of $\geq$ 0.9 ml/g;
   ii) matting agents having a BET surface of $\geq$ 150 m$^2$/g;
   iii) matting agents having an oil number of $\geq$ 150g/100g;
   iv) matting agents having at least one crosslinkable group; and
   v) combinations thereof.

2. The photosensitive element of Claim 1 wherein the matted layer has a surface opposite the photopolymerizable layer that is smooth or substantially smooth.

3. The photosensitive element of Claim 1 wherein the matting agent is capable of forming the depressions after contacting the matte layer to the photopolymerizable layer and during exposure to actinic radiation and treatment.

4. The photosensitive element of Claim 1 wherein the matting agent has a pore volume of 1.0-2.5 ml/g.

5. The photosensitive element of Claim 1 wherein the matting agent has a BET surface of $\geq$ 200 m$^2$/g.

6. The photosensitive element of Claim 1 wherein the matting agent has an oil number of $\geq$ 200 g/100 g.

7. The photosensitive element of Claim 1 wherein the matting agent is filled and/or loaded with at least one ethylenically unsaturated compound photopolymerizable by actinic radiation.

8. The photosensitive element of Claim 1 wherein the matting agent having at least one crosslinkable group contains at least one ethylenically unsaturated group photopolymerizable by actinic radiation.

9. The photosensitive element of Claim 1 wherein the matting agent is a matting agent with a mean particle size of $\geq$ 3 µm.

10. The photosensitive element of Claim 1 wherein the matting agent is a matting agent with a mean particle size of 3-25 µm.

11. The photosensitive element of Claim 1 wherein the matting agent is a matting agent with a mean particle size of

≥ 3 μm, a pore volume of ≥ 0.9 ml/g, and oil number of ≥ 150 g/100 g.

12. The photosensitive element of Claim 1 wherein the matting agent is a matting agent with a mean particle size of ≥ 3 μm, a pore volume of ≥ 0.9 ml/g, oil number of ≥ 150 g/100 g, and a BET surface of ≥150 m$^2$/g.

13. The photosensitive element of Claim 1 wherein the matting agent is a matting agent with a mean particle size of ≥3 μm, a pore volume of 1.0-2.5 ml/g, oil number of ≥ 200 g/100 g, and a BET surface of ≥ 200 m$^2$/g.

14. The photosensitive element of Claim 1 wherein the matting agent comprises ≤ 20 % by weight of particles with a particle size of ≥ 15 μm, the weight percentage based on the total amount of matting agent.

15. The photosensitive element of Claim 1 wherein the matting agent comprises ≥ 10 % by weight of a matting agent with a particle size of ≤ 3 μm, the weight percentage based on the total amount of matting agent.

16. The photosensitive element of Claim 1 wherein the matted layer comprises at least one matting agent selected from the group consisting of silicic acids, silicates, and/or aluminates.

17. The photosensitive element of Claim 1 wherein the matted layer comprises at least one polymeric binder selected from the group consisting of polyamides, polyvinyl alcohols, polyurethanes, urethane copolymers, polyvinyl pyrrolidones, polyethylene oxides, copolymers of ethylene and vinyl acetate, polyacrylates, polyesters, cellulose esters, cellulose ethers, and polyolefins.

18. The photosensitive element of Claim 1 wherein the matted layer comprises at least one pigment and/or dye.

19. The photosensitive element of Claim 1 wherein the matted layer further comprises an auxiliary agent selected from the group consisting of plasticizers, coating aids, viscosity modifying agents, wetting agents, surfactants, waxes, and dispersing agents.

20. The photosensitive element of Claim 1 wherein the matted layer further comprises at least one additive selected from the group consisting of an infrared-sensitive compound, a radiation opaque material, and wax.

21. . The photosensitive element of Claim 1 further comprising an additional layer between the matted layer and the elastomeric photopolymerizable layer, the additional layer selected from the group consisting of an elastomeric layer capable of becoming photosensitive, a wax layer, and a laser-radiation-sensitive layer.

22. The photosensitive element of Claim 1 further comprising an additional layer disposed above the matted layer, the additional layer selected from the group consisting of a wax layer, and a laser-radiation-sensitive layer.

23. The photosensitive element of Claim 1 further comprising a cover sheet on the matted layer opposite the photopolymerizable layer.

24. The photosensitive element of Claim 1 further comprising an IR-sensitive layer disposed above the matted layer opposite the photopolymerizable layer.

25. A process for preparing a photosensitive element comprising

(a) providing an elastomeric photopolymerizable layer disposed on a support wherein the photopolymerizable layer contains at least one elastomeric binder, at least one ethylenically unsaturated compound photopolymerizable by actinic radiation, and at least one photoinitiator or photoinitiator system, the elastomeric photopolymerizable layer having a surface opposite the support that defines a plane;
(b) providing a matted layer comprising a polymeric binder and at least one matting agent, the at least one matting agent capable of forming depressions from the plane into the photopolymerizable layer, and selected from the group consisting of

il matting agents having a pore volume of ≥0.9 ml/g;
ii) matting agents having a BET surface of ≥ 150 m$^2$/g ;
iii) matting agents having an oil number of ≥ 150g/100g;
iv) matting agents having at least one crosslinkable group; and

v) combinations thereof,

and

(c) contacting the matted layer with the surface of the elastomeric photopolymerizable layer forming the photosensitive element.

26. The process of Claim 25 wherein the photosensitive element further comprises an additional layer between the matted layer and the elastomeric photopolymerizable layer, the additional layer selected from the group consisting of an elastomeric layer capable of becoming photosensitive, and a wax layer, the process further comprising: providing the additional layer to the element by either (d') providing the additional layer on the surface of the elastomeric photopolymerizable layer, and contacting the matted layer to a surface of the additional layer opposite the elastomeric photopolymerizable layer, or (d'') providing the additional layer on the matted layer and contacting the additional layer to the surface of the elastomeric photopolymerizable layer.

27. The process of Claim 25 wherein contacting is by laminating the matted layer on the surface of the photopolymerizable layer opposite the support.

28. The process of Claim 25 wherein contacting comprises:

(1) passing into the nip of a calender a mass of a hot photopolymerizable composition comprising at least one elastomeric polymer, at least one ethylenically unsaturated compound photopolymerizable by actinic radiation, and at least one photoinitiator or photoinitiator system, and
(2) while hot, calendering the photopolymerizable composition between the support and a cover element to form the photopolymerizable layer therebetween, wherein the cover element comprises a cover sheet and the matted layer, the matted layer being adjacent to the photopolymerizable layer.

29. A process for preparing a flexographic printing plate comprising

(A) exposing to actinic radiation through a photomask a photosensitive element comprising

a) a support,
b) at least one elastomeric photopolymerizable layer on the support containing at least one elastomeric binder, at least one ethylenically unsaturated compound photopolymerizable by actinic radiation, and at least one photoinitiator or photoinitiator system, the elastomeric photopolymerizable layer having a surface opposite the support that defines a plane, and
c) a matted layer disposed above the surface of the photopolymerizable layer comprising a polymeric binder and at least one matting agent, the at least one matting agent capable of forming depressions from the plane into the photopolymerizable layer, and selected from the group consisting of

i) matting agents having a pore volume of $\geq 0.9$ ml/g
ii) matting agents having a BET surface of $\geq 150$ m$^2$/g
iii) matting agents having an oil number of $\geq 150$g/100g;
iv) matting agents having at least one crosslinkable group; and
v) combinations thereof,

forming polymerized areas and unpolymerized areas in the photopolymerizable layer;

(B) removing the photomask, and
(C) treating the exposed photosensitive element to remove unpolymerized areas and form a relief surface suitable for printing,

wherein the polymerized areas contain a plurality of depressions from the plane into the polymerized areas.

30. The process of Claim 29 wherein the plurality of depressions are located on a printing surface, and the depressions are **characterized by** surface pits such that at least 40% of printing surface is covered with surface pits.

31. The process of Claim 29 wherein the plurality of depressions are located on a printing surface, and the depressions are **characterized by** surface pits such that at least 50% of printing surface is covered with surface pits.

**32.** The process of Claim 29 wherein the plurality of depressions are located on a printing surface, and the printing surface is free or substantially free of surface peaks.

**33.** The process of Claim 29 wherein the depressions are at least 2 microns in depth.

**34.** The process of Claim 29 wherein the depressions are **characterized by** surface pits which are present at a surface pit density of at least 500 pits per square millimeter.

**35.** The process of Claim 29 wherein the plurality of depressions are located on a printing surface, and the depressions are **characterized by** surface pits $\geq 2$ microns in depth which are present at a frequency of greater than about 80 surface pits per square millimeter on the printing surface.

**36.** The process of Claim 29 wherein the plurality of depressions are located on a printing surface, and the depressions are **characterized by** surface pits $\geq 3$ microns in depth which are present at a frequency of greater than about 30 surface pits per square millimeter on the printing surface.

**37.** The process of Claim 29 wherein the plurality of depressions are located on a printing surface, and the depressions are **characterized by** surface pits $\geq 4$ microns in depth which are present at a frequency of greater than about 10 surface pits per square millimeter on the printing surface.

**38.** The process of Claim 29 wherein the plurality of depressions are located on a printing surface, and the depressions are **characterized by** surface pits $\geq 5$ microns in depth which are present at a frequency of greater than about 1 surface pits per square millimeter on the printing surface.

**39.** The process of Claim 29 wherein the plurality of depressions are located on a printing surface and have a depression aspect ratio between 10: 1 to 2:1.

**40.** The process of Claim 29 wherein the plurality of depressions are located on a printing surface and have a depression aspect ratio of at least 2: 1 .

**41.** The process of Claim 29 wherein the plurality of depressions are located on a printing surface and have a depression aspect ratio of less than 10:1.

**42.** The process of Claim 29 wherein the depressions are **characterized by** a surface pit opening size of at least 5 microns.

**43.** The process of Claim 29 wherein the plurality of depressions are located on a printing surface that has no or substantially no surface peaks above the plane of the photopolymerizable layer.

**44.** The process of Claim 29 wherein the treating step (C) is selected from the group consisting of

(1) developing with at least one washout solution selected from the group consisting of solvent solution, aqueous solution, semi-aqueous solution, and water; and
(2) heating the element to a temperature sufficient to cause the unpolymerized portions to melt, flow, or soften, and contacting the element with an absorbent material to remove the unpolymerized portions.

**45.** The process of Claim 29 wherein the exposing step (A) occurs in a vacuum.

**46.** The process of Claim 29 wherein the exposing step (A) occurs in the absence of atmospheric oxygen.

**47.** The process of Claim 29 wherein the exposing step (A) occurs in the presence of atmospheric oxygen.

**48.** The process of Claim 29 further comprising exposing the photosensitive element to ultraviolet radiation between 200 and 300 nm, prior to the treating step (C).

**49.** The process of Claim 29 wherein the photosensitive element comprises an integrated photomask and the exposing step (A) occurs in the presence of atmospheric oxygen, further comprising exposing the photosensitive element to ultraviolet radiation between 200 and 300 nm, prior to the treating step (C).

**50.** The process of Claim 29 wherein the removing step (B) occurs during the treating step (C).

**51.** The photosensitive element of Claim 3 wherein the exposure occurs in a vacuum.

**52.** The process of Claim 29 wherein the plurality of depressions are located on a printing surface, and the depressions are **characterized by** surface pits such that at least 30% of printing surface is covered with surface pits.

**53.** A flexographic printing plate produced by the process of Claim 29.

**54.** The process of Claim 29 wherein the plurality of depressions are located on a printing surface, and the depressions are **characterized by** surface pits such that at least 10% of printing surface is covered with surface pits.

**55.** The process of Claim 29 wherein the plurality of depressions are located on a printing surface, and the depressions are **characterized by** surface pits such that at least 60% of printing surface is covered with surface pits.

**56.** The process of Claim 29 wherein the plurality of depressions are located on a printing surface, and the depressions are **characterized by** surface pits such that 10 to 40% of printing surface is covered with surface pits.

**57.** The process of Claim 29 wherein the plurality of depressions are located on a printing surface, and the depressions are **characterized by** surface pits such that 30 to 60% of printing surface is covered with surface pits.

**58.** The process of Claim 29 wherein the depressions are **characterized by** surface pits which are present at a surface pit density of at least 350 pits per square millimeter.

**59.** The process of Claim 29 wherein the depressions are **characterized by** surface pits which are present at a surface pit density of 200 to 3000 pits per square millimeter.

**60.** The process of Claim 29 wherein the depressions are **characterized by** surface pits which are present at a surface pit density of 350 to 2500 pits per square millimeter.

**61.** The process of Claim 29 wherein the depressions are **characterized by** surface pits which are present at a surface pit density of 350 to 1000 pits per square millimeter.

**62.** The process of Claim 29 wherein the depressions are **characterized by** a surface pit opening size of 5 to 30 microns.

**63.** The process of Claim 29 wherein the depressions are **characterized by** a surface pit opening size of 8 to 22 microns.

**64.** The process of Claim 29 wherein the depressions are **characterized by** a surface pit opening size of 10 to 15 microns.

**65.** The process of Claim 29 wherein the matted layer has a surface opposite the photopolymerizable layer that is smooth or substantially smooth.

**66.** The photosensitive element of Claim 29 wherein the matted layer comprises at least one pigment and/or dye.

**67.** The process of Claim 29 wherein the matted layer further comprises an auxiliary agent selected from the group consisting of plasticizers, coating aids, viscosity modifying agents, wetting agents, surfactants, waxes, and dispersing agents.

**68.** The process of Claim 29 wherein the matted layer further comprises at least one additive selected from the group consisting of an infrared-sensitive compound, a radiation opaque material, and wax.

**69.** The process of Claim 29 further comprising an additional layer between the matted layer and the elastomeric photopolymerizable layer, the additional layer selected from the group consisting of an elastomeric layer capable of becoming photosensitive, a wax layer, and a laser-radiation-sensitive layer.

**70.** The process of Claim 29 further comprising an additional layer disposed above the matted layer, the additional layer selected from the group consisting of a wax layer, and a laser-radiation-sensitive layer.

**71.** The process of Claim 29 further comprising an IR-sensitive layer disposed above the matted layer opposite the photopolymerizable layer.

**72.** The process of Claim 29 wherein the photopolymerizable layer further comprises a second photoinitiator sensitive to actinic radiation between 200 and 300 nm.

**73.** The process of Claim 72 wherein the second photoinitiator is sensitive to radiation between 245 and 265 nm.

**74.** The process of Claim 48 wherein the photopolymerizable layer further comprises a second photoinitiator sensitive to actinic radiation between 200 and 300 nm.

FIG. 1

FIG. 2

FIG. 3

FIG. 4

FIG. 5A

FIG. 5B

FIG. 5C

FIG. 5D

FIG. 6